# EUROPEAN PATENT SPECIFICATION

(11) **EP 4 239 035 B1**
(45) Date of publication and mention of the grant of the patent: **02.07.2025**
(21) Application number: 23155676.2
(22) Date of filing: 08.02.2023
(51) Int. Cl.: C09K 9/02, C08G 61/12, G02F 1/1516, C08L 65/00, C09D 165/00, H10K 85/10

(54) **HIGH TRANSPARENCY ELECTROCHROMIC POLYMERS**
ELEKTROCHROME POLYMERE MIT HOHER TRANSPARENZ
POLYMÈRES ÉLECTROCHROMES À TRANSPARENCE ÉLEVÉE

(30) Priority: 09.02.2022 US 202217668300; 19.05.2022 US 202217748383; 04.01.2023 US 202318093287
(43) Date of publication of application: 06.09.2023
(73) Proprietor: Ambilight Inc, Grand Cayman, KY1-1003 (KY)
(72) Inventor: Mei, Jianguo, West Lafayette, 47906 (US); Pandit, Vaidehi, West Lafayette, 47906 (US); Wang, Zhiyang, West Lafayette, 47906 (US); You, Liyan, 47906 West Lavayette (US)
(74) Representative: Marks & Clerk LLP

(56) References cited:
- HSIAO SHENG-HUEI ET AL: "Fluorescent and electrochromic polymers from 2,8-di(carbazol-9-yl)dibenzothiophene and itsS,S-dioxide derivative", DYES AND PIGMENTS, ELSEVIER APPLIED SCIENCE PUBLISHERS BARKING, GB, vol. 134, 29 June 2016 (2016-06-29), pages 51 - 63, XP029708707, ISSN: 0143-7208, DOI: 10.1016/J.DYEPIG.2016.06.043
- JEONG DONG-CHEOL ET AL: "Effects of Substituent on Binaphthyl Hinge-Containing Conductive Polymers", MACROMOLECULES, vol. 45, no. 24, 10 December 2012 (2012-12-10), US, pages 9571 - 9578, XP093073488, ISSN: 0024-9297, DOI: 10.1021/ma301899e
- LIU JIAN ET AL: "Electrochromic polymer achieving synchronous electrofluorochromic switching for optoelectronic application", ORGANIC ELECTRONICS, vol. 51, 18 September 2017 (2017-09-18), pages 295 - 303, XP085320386, ISSN: 1566-1199, DOI: 10.1016/J.ORGEL.2017.09.022
- KOCAEREN AYSEL AYDIN: "Synthesis and electrochromic performance of a novel polymer based on an oxidative polymer derived from carbazole and thiophene", JOURNAL OF POLYMER RESEARCH, SPRINGER NETHERLANDS, DORDRECHT, vol. 23, no. 4, 8 March 2016 (2016-03-08), pages 1 - 10, XP035643812, ISSN: 1022-9760, [retrieved on 20160308], DOI: 10.1007/S10965-016-0961-1
- MERVE I&#X307;ÇLI-ÖZKUT ET AL: "Substituent and heteroatom effects on the electrochromic properties of similar systems", JOURNAL OF POLYMER SCIENCE PART A: POLYMER CHEMISTRY, vol. 50, no. 4, 28 October 2011 (2011-10-28), pages 615 - 621, XP055194200, ISSN: 0887-624X, DOI: 10.1002/pola.25047

## Description

This application claims priority to and benefits of US Application No. 18/093,287, filed on January 4, 2023, US Application No. 17/748,383, filed on May 19, 2022, and US Application No. 17/668,300, filed on February 9, 2022.

### TECHNICAL FIELD

The present disclosure is related to a new type of electrochromic polymers that comprise meta-conjugated linkers and aromatic moieties, which present a high transparency in the visible light region in the neutral state. The polymers become highly absorbing in the visible light and near-infrared region and thus colored when their films are being oxidized. A device incorporating such conjugated electrochromic polymer films with a high optical contrast and a high transmittance is also disclosed.

### BACKGROUND

Electrochromic devices allow to adjust light transmittance and control solar-heat gain. In comparison with inorganic-based electrochromic devices made through the vacuum sputtering process, polymer-based electrochromic windows can be manufactured through roll-to-roll coating and lamination. It thus renders a low-cost production and manufacturing flexibility. Polymer based electrochromic devices are typically composed of conjugated electrochromic polymers (ECPs), which feature fully conjugated polymer backbone made of sp² hybridized carbons. Conventionally, ECPs typically have strong absorbance in the visible light region and are thus colored in their neutral state. When they are oxidized, their absorption is shifted toward near-infrared (near-IR) region and they become transmissive in the visible light region. However, the oxidized polymers still have weak absorption in the visible light region, leading to residue colors. The problem becomes more severe when the polymer films are thick. As a result, it negatively impacts optical contrast of the polymers. Furthermore, it limits the highest optical transmittance a conjugated electrochromic polymer can achieve. In addition, conventional ECPs in the neutral state blocks visible light through the film and allow near-IR light passing through; while in the transmissive state, it allows visible light passing through and blocks near-IR light. This combination is not effective for thermal management and control the solar-heat gain (SHG). SHG describes the way radiation from the sun is turned into heat through a window product.

D1 (Fluorescent and electrochromic polymers from 2,8-di(carbozal-9-yl)dibenzothiophene and its S,S-dioxide derivative", DYES AND PIGMENTS, ELSEVIER APPLIED SCIENCE PUBLISHERS, vol. 134, pages 9571-9578, 29 June 2016) proposes using a carbazole endcapped dibenzothiophene and dibenzothiophene-S,S-dioxide monomers to synthesize an electrochromic polymer.

D2 ("Effects of Substituent on Binaphthyl Hinge-Containing Conductive Polymers", Macromolecules, vol. 45, no. 24, 10 December 2012) describes synthesizing a polymer which contains a binaphthyl molecular hinges and oligothiophene electroactive segments.

D3 ("Electrochromic polymer achieving synchronous electrofluorochromic switching for optoelectronic application", ORGANIC ELECTRONICS, vol.51, pages 295-303) proposes synthesizing a polymer which includes biphenyl in a polythiophene backbone to form a twisting conformation.

D4 ("Synthesis and electrochromic performance of a novel polymer based on an oxidative polymer derived from carbazole and thiophene", JOURNAL OF POLYMER RESEARCH, SPRINGER, vol. 23, no. 4, pages 1-10, 8 March 2016) proposes synthesizing a purple electrochromic polymer, denoted polymer B2.

D5 ("Substituent and heteroatom effects on the electrochromic properties of similar systems", Journal of Polymer Science Part A: Polymer Chemistry, vol. 50, no. 4, pages 615-621, 28 October 2011) discloses synthesizing different derivatives of 3,4-propylenedioxythiophene/selenophene having different substituent groups and investigating their optical properties.

### SUMMARY

Aspects of the present invention provide an electrochromic polymer, as set out by the appended set of claims. In some embodiments, the disclosed electrochromic polymer is anodically-coloring electrochromic polymer (AC-ECP), becoming colored when it is oxidized.

In some embodiments, the absorption maxima ( 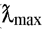 , the wavelength at which the polymer has its strongest photon absorption) are less than 410 nm in the neutral state. In some embodiments, the disclosed electrochromic polymer is colorless in the neutral state, while it is colored and visible and near-infrared absorbing in the oxidized state. The oxidized electrochromic polymer has an absorption coefficient larger than 10⁴ cm⁻¹ in the visible and/or near-IR region and thus colored in the oxidized state.

In spite of their high bandgaps, the disclosed electrochromic polymers still have relatively low oxidation potential in the ranges of 0.1-1.5 V inclusive versus Ag/AgCl electrode in some embodiments.

The MCL comprises at least one of an aromatic structure, or a fused aromatic structure, or the combinations thereof. The aromatic structure comprises a benzene or heterocyclic structure. The fused aromatic structure comprises a fused benzene structure or a fused heterocyclic structures or a fused benzene and heterocyclic structure.

In some embodiments, for the disclosed electrochromic polymers, the one or more MCLs and the one or more Ars are arranged in an alternative or random fashion with a general formula of 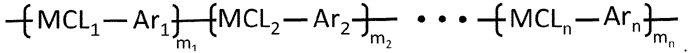 In the structures here, n is an integer greater than 0 and each of m₁, m₂, ... , mₙ is an integer equal to or greater than 0 with at least one of m₁, m₂, ... , mₙ is greater than 0. The one or more MCLs (or the one or more Ars) can be the same as or different from each other.

In some embodiments, the thiophene-based unit comprises a formula of 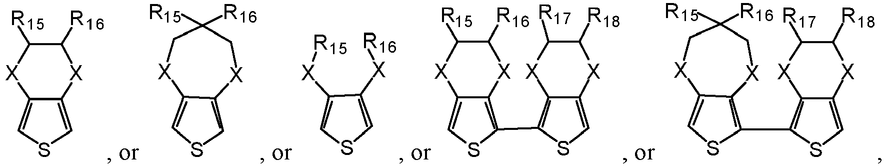 or 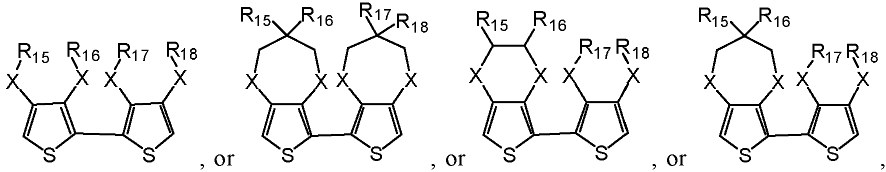 or 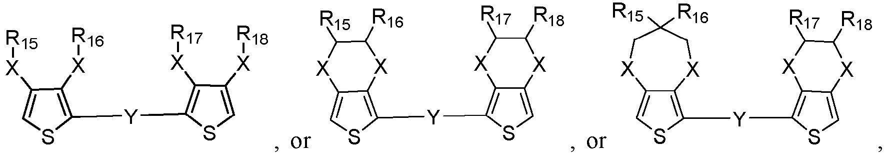 or 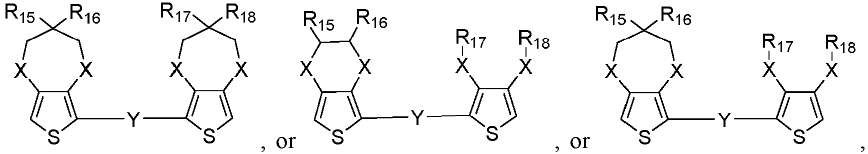 or a combination thereof,
wherein X is S, Se, N, C, or O; each of R₁₅ - R₁₈ is independently selected from the following substituents, including, but not limited to, hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀alkoxycarbonylalkyl, C₁-C₃₀ alkylthio, C₁-C₃₀aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl, C₅-C₃₀ cycloalkylalkyl, C₅-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl. Y is any one or more of Ars, or aromatic structures, or fused aromatic structures, or a combinations thereof.

In some embodiments, X in the thiophene-based unit is O.

In some embodiments, the disclosed electrochromic polymers comprise a formula of 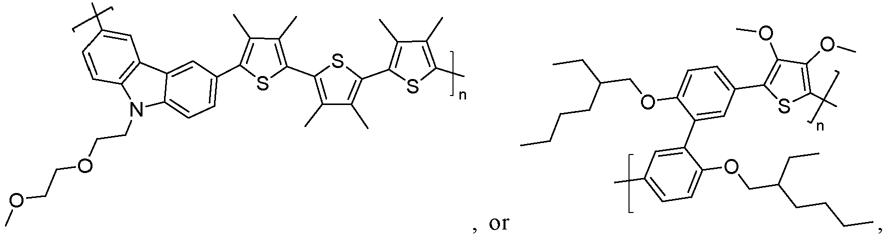 or 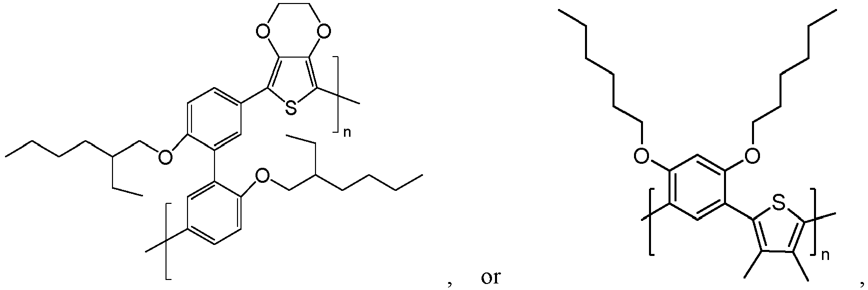 or 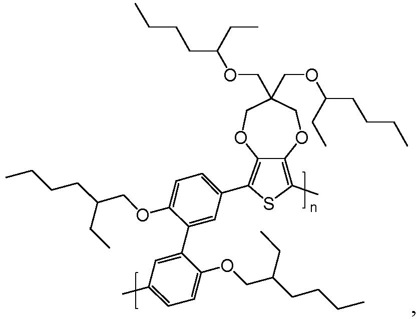 or 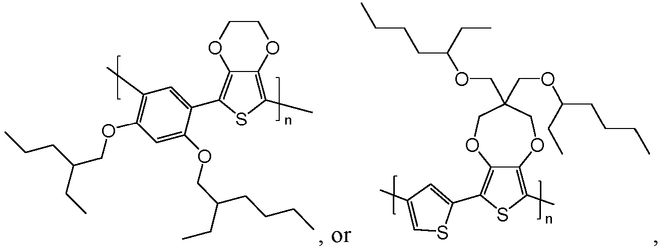 or 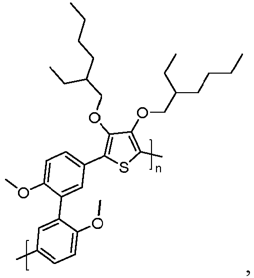 or 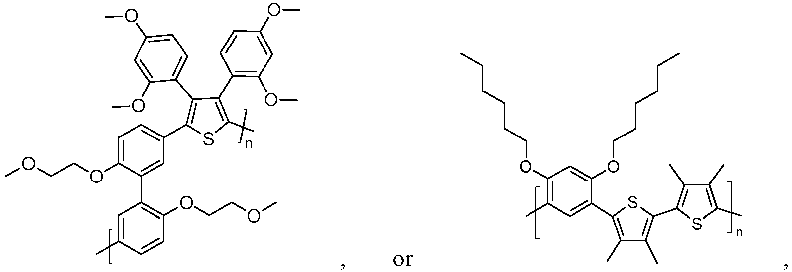 or 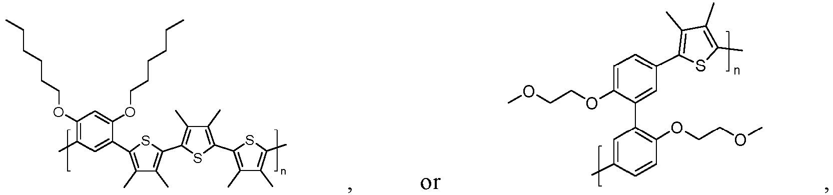 or 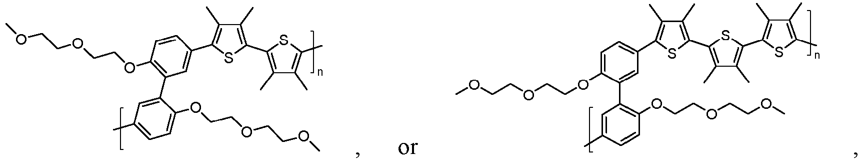 or 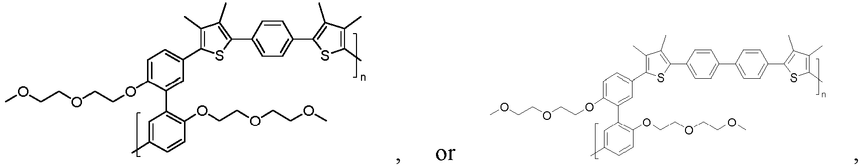 or 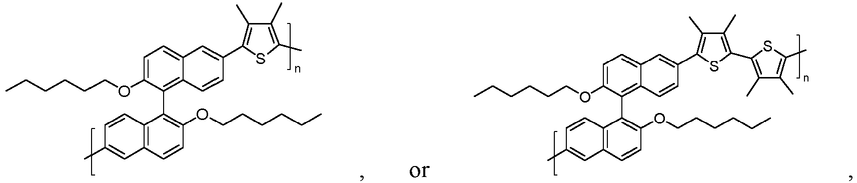 or 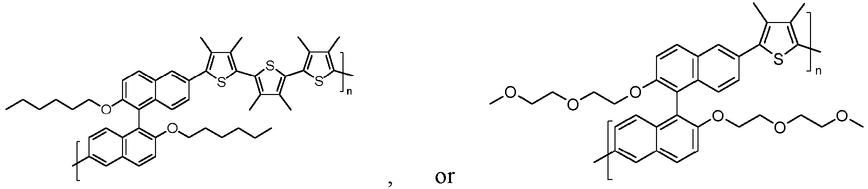 or 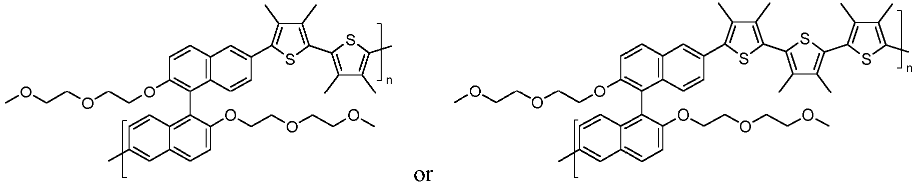 or 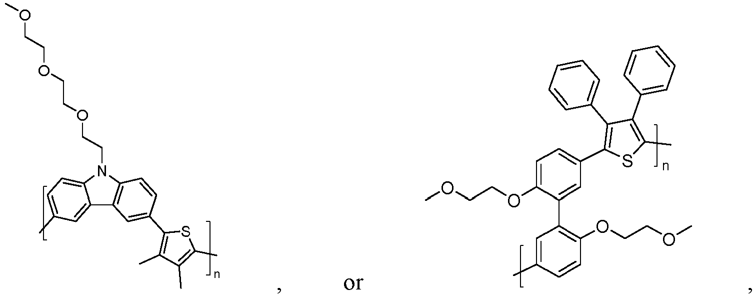 or 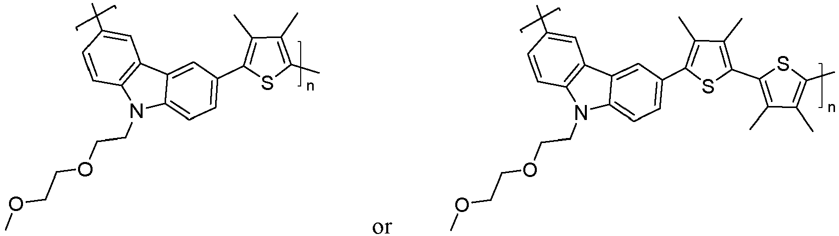 or 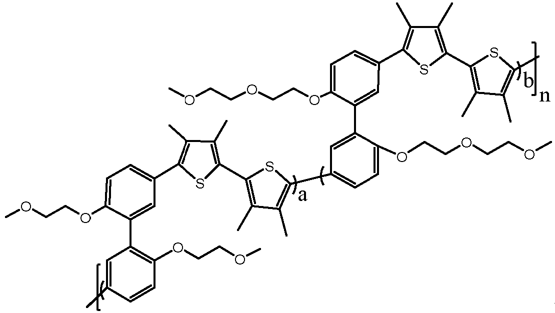 wherein n, and m are integers greater than 0, a and b are integers equal to or greater than 0 with at least one of a and b is greater than 0.

### BRIEF DESCRIPTION OF THE DRAWINGS

Certain features of various embodiments of the present technology are set forth with particularity in the appended claims. A better understanding of the features and advantages of the technology will be obtained by reference to the following detailed description that sets forth illustrative embodiments, in which the principles of the invention are utilized, and the accompanying drawings below. For the purpose of illustrating the invention, the drawings show aspects of one or more embodiments of the invention. However, it should be understood that the present invention is not limited to the precise arrangements and instrumentalities shown in the drawings.
FIGS. 1(A)-(B) are diagrams representing the different color changing mechanisms of the disclosed ECP (FIG. 1(A)) compared to conventional ECP (FIG. 1(B)).
FIG. 2 is the CV data of an exemplary solid-state device using an example ECP-1, according to one embodiment.
FIG. 3 is the switching kinetics of the exemplary solid-state device using the example ECP-1 at 545 nm, according to one embodiment.
FIG. 4 are the absorbance spectra of the exemplary ECP-1 thin film at different voltages, according to one embodiment.
FIG. 5 is the CV data of an exemplary solid-state device using another example ECP-2, according to one embodiment.
FIG. 6 is the switching kinetics of the exemplary solid-state device using the example ECP-2 at 550nm, according to one embodiment.
FIG. 7 are the absorbance spectra of the exemplary ECP-2 thin film at different voltages, according to one embodiment.
FIG. 8 are the absorbance spectra of the exemplary ECP-6 solution 0.1 mg/mL in dichloromethane at different voltages, according to one embodiment.
FIG. 9 are the absorbance spectra of the exemplary ECP-7 solution 0.1 mg/mL in dichloromethane at different voltages, according to one embodiment.

### DETAILED DESCRIPTION OF EMBODIMENTS

In the following description, certain specific details are set forth in order to provide a thorough understanding of various embodiments of the invention. However, one skilled in the art will understand that the invention may be practiced without these details. Moreover, while various embodiments of the invention are disclosed herein, many adaptations and modifications may be made within the scope of the invention in accordance with the common general knowledge of those skilled in this art. Such modifications include the substitution of known equivalents for any aspect of the invention in order to achieve the same result in substantially the same way.

Unless the context requires otherwise, throughout the present specification and claims, the word "comprise" and variations thereof, such as "comprises" and "comprising" are to be construed in an open, inclusive sense, that is as "including, but not limited to." Recitation of numeric ranges of values throughout the specification is intended to serve as a shorthand notation of referring individually to each separate value falling within the range inclusive of the values defining the range, and each separate value is incorporated in the specification as it was individually recited herein. Additionally, the singular forms "a" "an", and "the" include plural referents unless the context clearly dictates otherwise.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment, but maybe in some instances. Furthermore, the particular features, structures, or characteristics may be combined in any suitable manner in one or more embodiments.

The present disclosure is related to a new type of electrochromic polymers. The electrochromic polymer disclosed in this application consists of a polymer backbone comprising one or more meta-conjugated linkers (MCLs) and one or more aromatic moieties (Ars). Each of the one or more MCLs is partially conjugated with the one or more Ars at meta positions of the one or more MCLs to form the polymer backbone of an electrochromic polymer. In some embodiments, the electrochromic polymer disclosed in this application consists of a repeat unit comprising one or more MCLs and one or more Ars, where meta-conjugation is introduced along the polymer backbone through the use of the MCLs. In some embodiments, the electrochromic polymer is anodically-coloring electrochromic polymer (AC-ECP), becoming colored when it is oxidized.

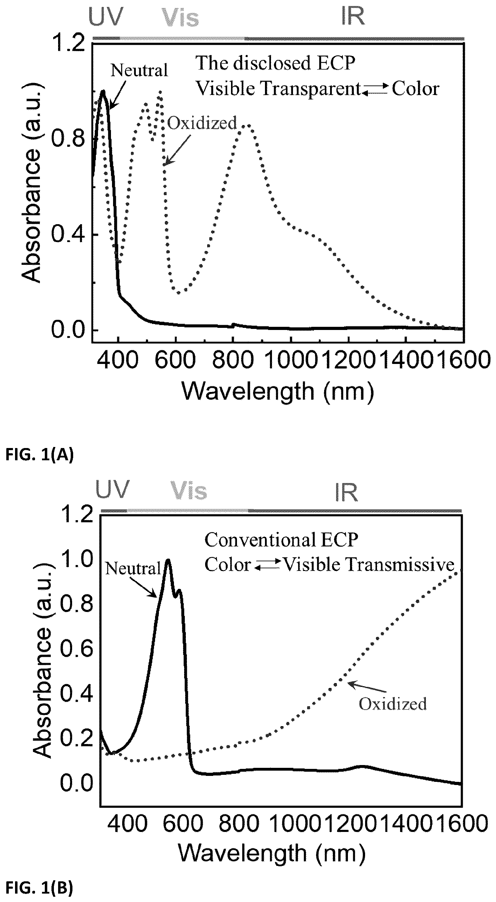

As illustrated in FIG. 1, conventional conjugated ECPs (FIG. 1(B)) are fully conjugated and have strong absorbance in the visible light region and are thus colored in their neutral state, while when oxidized (oxidized state), their absorption is shifted toward near-IR region and they become transmissive. However, the oxidized polymers still have weak absorption in the visible light region, leading to residue colors. On the other hand, as illustrated for one example disclosed ECP in FIG. 1(A), the ECP exhibits substantially no absorption after 450 nm in the neutral state and has several absorption peaks in visible light range and the near infrared range in the oxidized state, demonstrating coloring in the visible light range and near-infrared absorbing.

The disclosed electrochromic polymers allows passing or blocking of visible light and near-IR light to be synchronized, which is in one embodiment very useful in an electrochromic window for the management of solar heat gain. The disclosed electrochromic polymers are transparent in the neutral state, and are colored and IR-absorbing in the oxidized state, which are highly desired in order to achieve a high optical contrast, a high transmittance and a synergistic solar-heat gain.

The disclosed electrochromic polymers are transparent in the visible light region in the neutral state and are colored in the oxidized state. For example, the disclosed electrochromic polymers may have a transmittance of at least 60% in the visible light range (e.g., 450-750 nm) in the neutral state. In some embodiments, the disclosed electrochromic polymers may have a transmittance of at least 65%, 70%, 75%, 80%, 85%, 90%, 92%, 95%, 98%, or above in the range of 450-750 nm in the neutral state. In some embodiments, the disclosed electrochromic polymers are transparent in the visible light range in the neutral state. In the oxidized state, the disclosed electrochromic polymers have absorption in the visible light range (e.g., about 360 to 750 nm) and the near-IR range (e.g., about 750 to 1600 nanometers), thereby being colored and near-infrared absorbing.

The disclosed electrochromic polymer has UV absorption and energy bandgap. An energy bandgap is the energy difference between the valence band of electrons and the conduction band. It is the minimum change in energy required to excite an electron up to a state in the conduction band where it can participate in conduction. Absorption onset ( 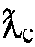 ) is the wavelength at higher than which the polymer has no photon absorption. The energy bandgap can be calculated as 1240/wavelength of absorption onset. In some embodiments, the electrochromic polymers disclosed in this application have an absorption onset at equal to or less than 450 nm in the neutral state. In some embodiments, the disclosed electrochromic polymer has an absorption onset at equal to or less than 440 nm, 430 nm, 420nm, 410nm, 405nm, or 400 nm in the neutral state. In some embodiments, the absorption maxima ( 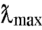 , the wavelength at which the polymer has its strongest photon absorption) are less than 420 nm in the neutral state. In some embodiments, the absorption maxima are less than 410 nm or 405 nm or 400 nm in the neutral state. In some embodiments, the disclosed electrochromic polymer has an energy bandgap equal to or higher than 2.8 eV and less than 4.0 eV in the neutral state. In some embodiments, the disclosed electrochromic polymer has an energy bandgap equal to or higher than 2.9, 3.0 or 3.1 eV and less than 4.0 eV in the neutral state. In some embodiments, the disclosed electrochromic polymer is colorless (e.g., no absorbance in 400-750 nm or 410-750 nm or 420-750 nm) or yellow (e.g., tailing absorption in 400-500 nm, or 410-500nm, or 420-500 nm or 400-480 nm, or 410-480 nm, or 420-480 nm or 400-450 nm, or 410-450 nm or 420-450 nm) in the neutral state and is colored and visible and near-IR absorbing in the oxidized state. The oxidized electrochromic polymer has an absorption coefficient larger than 10⁴ cm⁻¹ in the visible and/or near-IR region and thus colored in the oxidized state.

Due to substantial lack of absorbance in the visible light range in the neutral state and high absorbance in the visible light range in the oxidized state, the disclosed electrochromic polymers demonstrate high optical contrast and high optical transmittance when comparing with conventional ECPs. In spite of their high bandgaps, the disclosed electrochromic polymers have relatively low oxidation potential in the ranges of 0.1-1.5 V inclusive versus Ag/AgCl electrode in some embodiments. In some embodiments, the disclosed electrochromic polymers have low oxidation potential in the ranges of 0.1-1 V inclusive versus Ag/AgCl electrode. The relatively low oxidation potential can benefit cycling durability of ECPs. Thus, the disclosed electrochromic polymers can be successfully incorporated into a device with a good cycling stability/reliability and a high optical contrast.

The MCL comprises at least one of an aromatic structure, or a fused aromatic structure, or the combinations thereof. The aromatic structure comprises a benzene or heterocyclic structure. The fused aromatic structure comprises a fused benzene structure or a fused heterocyclic structures or a fused benzene and heterocyclic structure. In some embodiments, the MCL comprises at least one of benzene, or naphthalene, or five-membered heterocycle, or benzene fused five-membered heterocycle, or a combination of these structures. Side chains or aromatic side chains can also be introduced onto the MCL to adjust its performance, for example, solubility or processibility or stability.

In some embodiments, the one or more MCLs and the one or more Ars are arranged in an alternative or random fashion with a general formula of 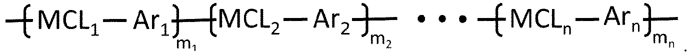 In the structure here, n is an integer higher than 0 and each of m₁, m₂, ... , mₙ is an integer equal to or higher than 0 with at least one of m₁, m₂, ... , mₙ is higher than 0. The one or more Ars are aromatic moieties, which may include one or more aromatic structures. Each of the one or more MCLs (or Ars) can be the same as or different from each other.

Meta-conjugation is introduced in the polymer backbone through the use of the one or more MCLs. Each of the one or more MCLs is partially conjugated in the polymer backbone by connecting with the one or more Ars through its meta-positions. For example, the meta-positions are two positions of the aromatic structure or a fused aromatic structure of the MCLs. When the meta-positions are connected, the pi electrons from an aromatic structure or a fused aromatic structure cannot be fully delocalized to another adjacently-connected unit through p-orbitals.

In some embodiments, an aromatic structure of the MCLs comprises a benzene structure or a five-membered heterocyclic structure, and the aromatic structure of the MCLs is substituted at meta-positions, which are the 1- and 3- positions on the aromatic structure. In some embodiments, a fused aromatic structure of the MCLs comprises naphthalene, and the fused aromatic structure is substituted at meta-positions, which are the 1- and 3-, or 1- and 4-, or 1- and 6- positions on naphthalene. In some embodiments, a fused aromatic structure of the MCLs comprises benzene fused with a five-membered heterocycle, and the fused aromatic structure is substituted at meta-positions, which are the 1- and 3-, or 1- and 5- positions on the benzene fused heterocycle.

Structures of the one or more MCLs and corresponding meta-positions include one of the following: 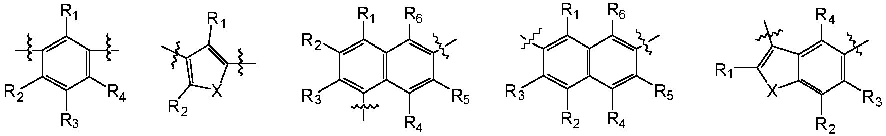 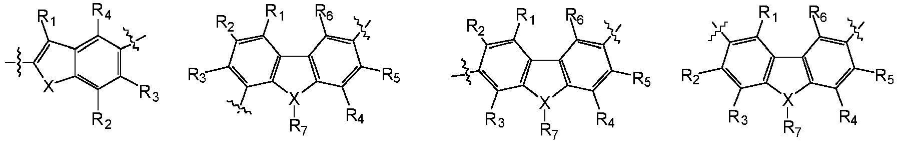 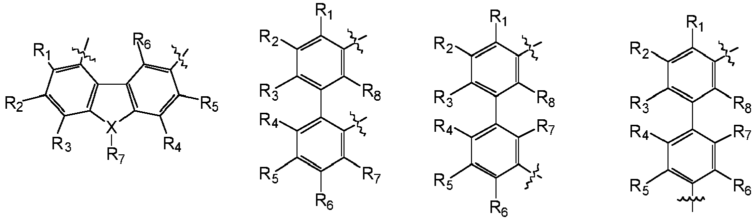 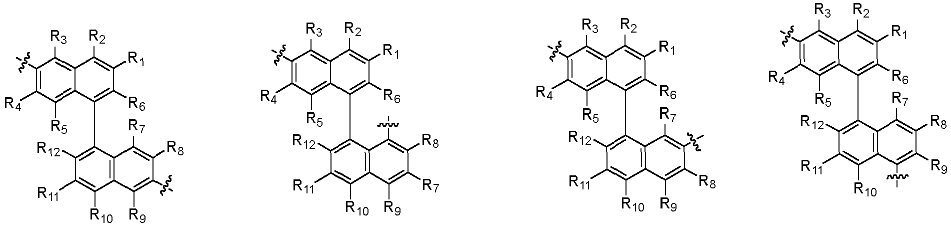 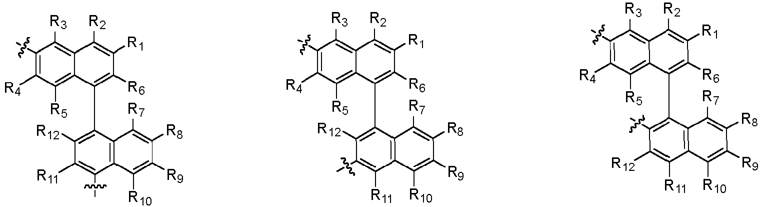 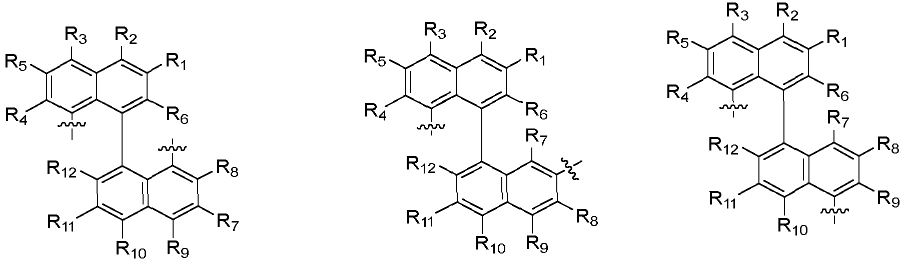 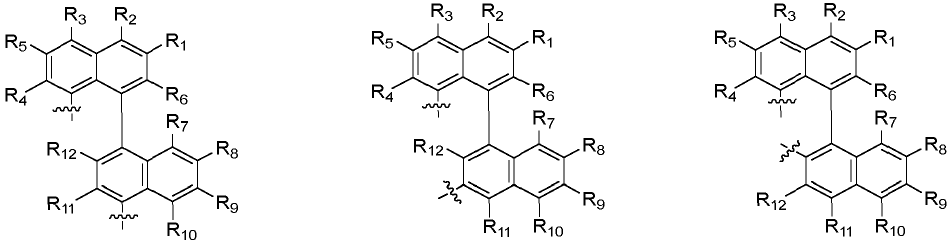 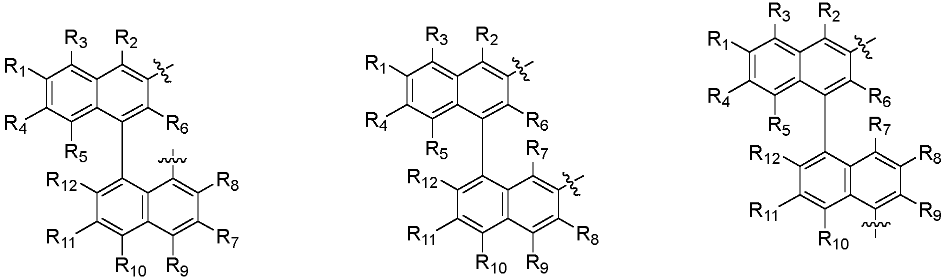 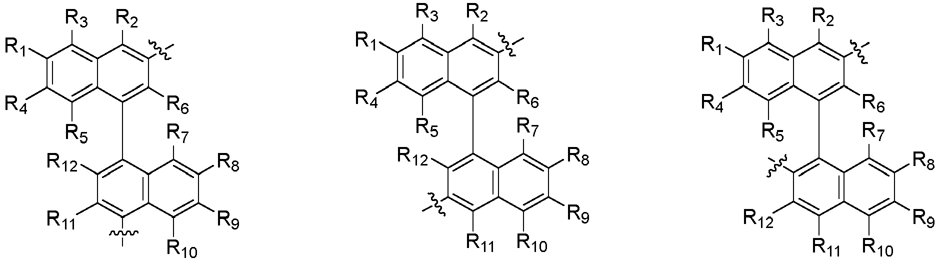 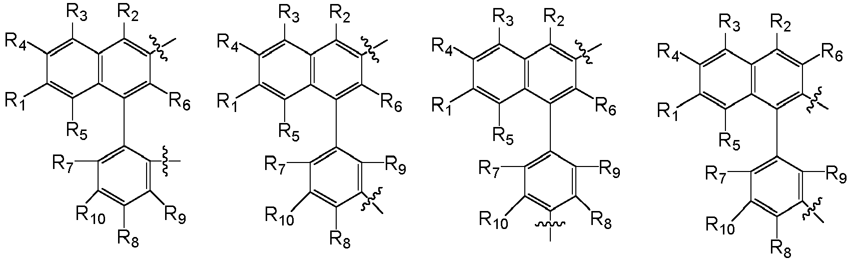 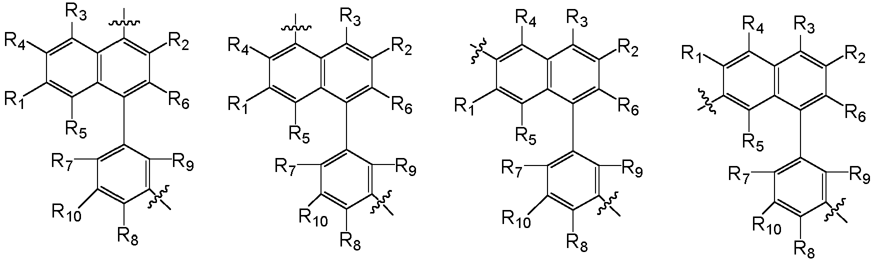 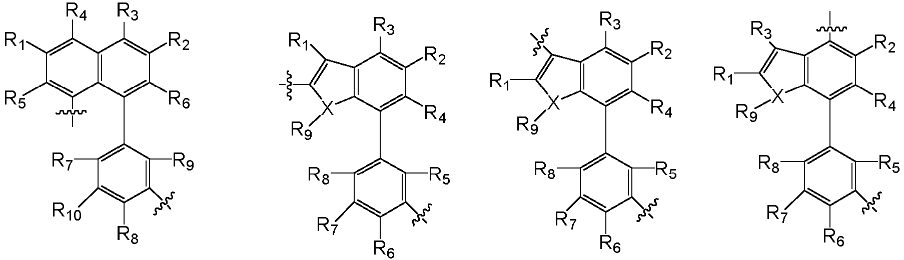 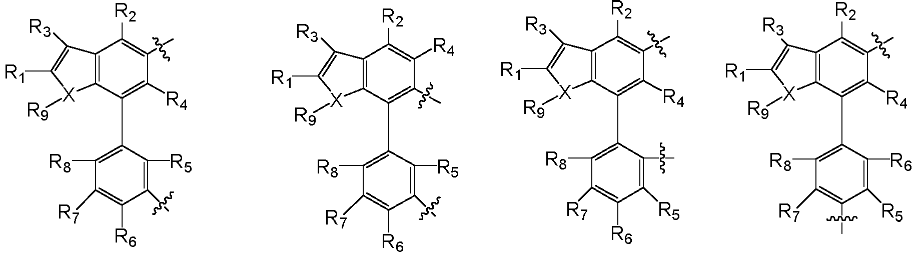 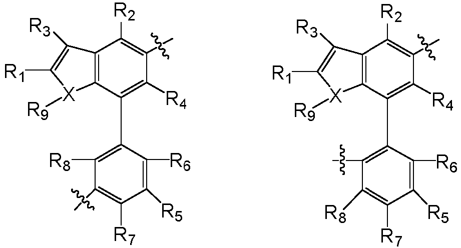 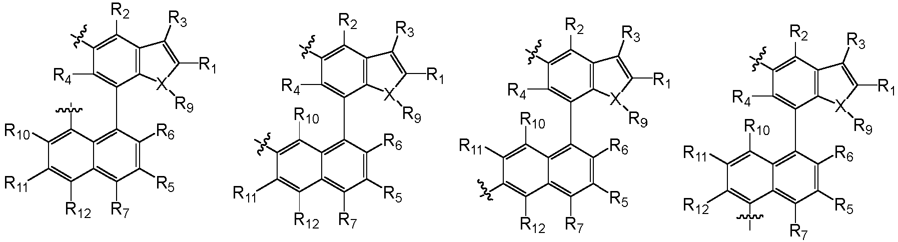 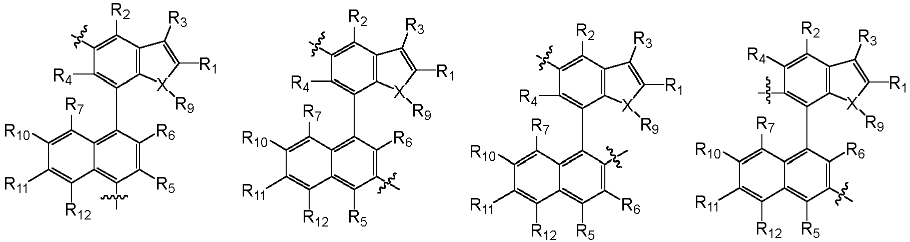 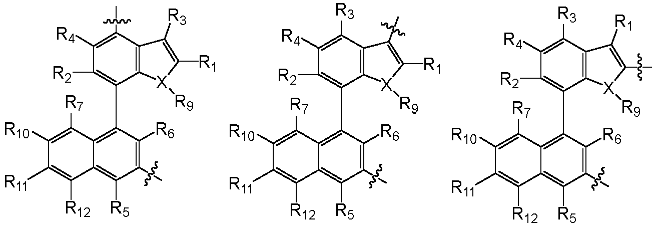 wherein X is S, Se, N, C, or O; R₁ - R₁₂ is independently selected from the following substituents, including, but not limited to, hydrogen, C₁-C₃₀ alkyl, C₂-C₃₀alkenyl, C₂-C₃₀alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀ aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl, C₅-C₃₀ cycloalkylalkyl, Cs-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl; and the wavy lines represent the meta-positions.

The one or more Ars include any one of a thiophene-based unit, a furan-based unit, a selenophene-based unit, or a pyrrole-based unit with a formula of 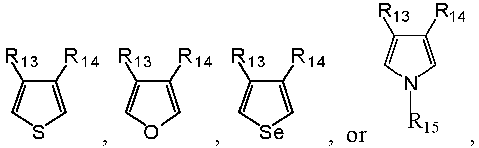 or any combination thereof. In the structures above, each of R_{13 ,}R₁₄ and R₁₅ is independently selected from the following substituents, including, but not limited to, hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl, C₅-C₃₀ cycloalkylalkyl, C₅-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl.

An example thiophene-based unit may include, but is not limited to, the formula of 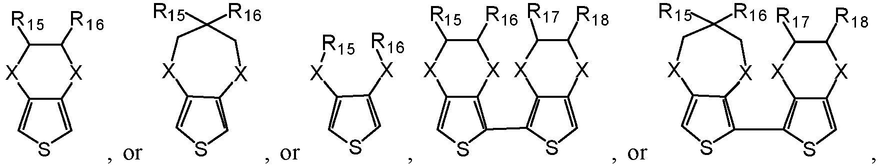 or 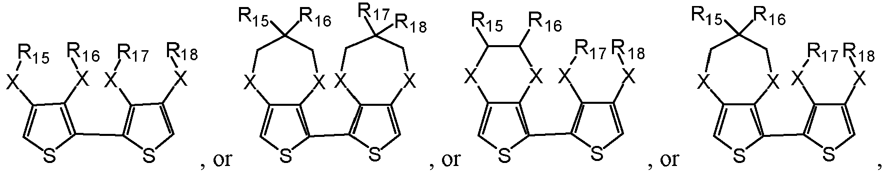 or 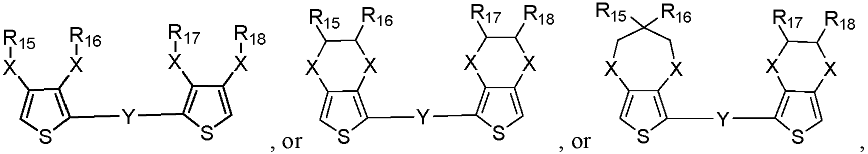 or 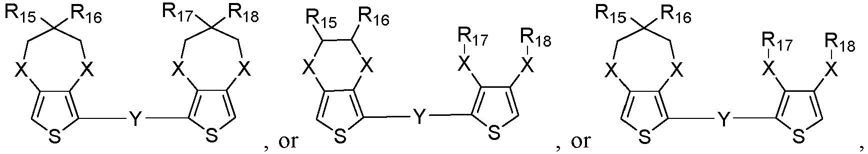 or a combination thereof. In the structures above, X is S, Se, N, C, or O; each of R₁₅ - R₁₈ is independently selected from the following substituents, including, but not limited to, hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl, C₅-C₃₀ cycloalkylalkyl, C₅-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl. Y is any one or more of Ars, or aromatic structures, or fused aromatic structures, or a combinations thereof.

In some embodiments, the X in the thiophene-based unit is O.

By introducing meta-conjugation into the electrochromic polymer backbone, the electronic conjugation along the polymer backbone is interrupted and leads to a high bandgap (>2.0 eV). Thus, the disclosed electrochromic polymer appears highly transmissive (or even transparent) in the neutral state. Oxidation of the ECP results in a lower bandgap (<1.5 eV), and the absorbance of the polymer is red-shifted from UV region to visible and near-IR region. Thus, the polymer becomes highly colored.

The one or more Ars might include one or more aromatic structures or fused aromatic structures. By controlling the types and amounts of the Ars, the redox potentials of the disclosed electrochromic polymer can be easily tuned while maintaining its high transparency within the visible light range in the neutral state. For example, more electron-rich units (e.g., dioxythiophenes) can be introduced onto the backbone to make the polymer more favorable to be oxidized, thereby decreasing its onset potential and improving its electrochemical stability and electrochromic cycling stability. The redox potentials of the disclosed electrochromic polymer can also be adjusted by varying substituents on MCLs (e.g., introducing alkoxy side chains).

The disclosed electrochromic polymers can be dissolved in a solvent, for example, toluene or p-xylene, which can be used for solution-processable film casting processes. By controlling the concentration of the polymer solution, a polymer thin film with a controllable thickness can be obtained. Furthermore, the excellent solubility makes the disclosed electrochromic polymers compatible with various casting methods, for example, spin-coating, spray-coating, and drop-casting. Manufacturing friendly process makes its extended applications feasible.

Examples are shown in the following.

### Embodiments

### Example 1 ECP-1

In some embodiments, the disclosed ECP-1 has a formula of

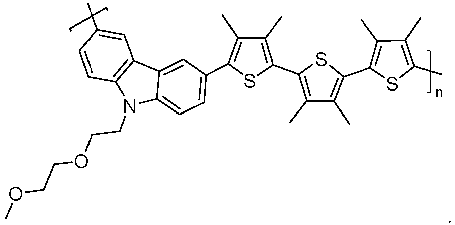

The ECP-1 is synthesized by preparing a carbazole-containing reaction unit and then polymerizing it with a dimer unit. The detail method includes the following steps:

### Step 1-1: preparing a carbazole-containing reaction unit (compound 2).

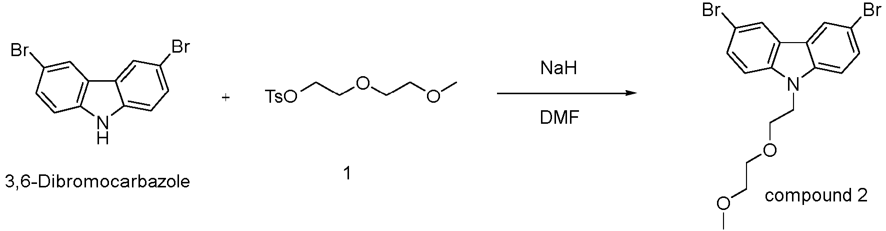

3,6-Dibromocarbazole is dissolved in DMF. Subsequently, 1.2 eq of NaH is added, and the mixture is stirred for 2 hours. Then 1.2 eq compound 1 is added into the reaction , and the mixture is stirred overnight. After that water is added into the reaction to precipitate out the solid. The suspension is filtered to get the desired product compound 2 as a white solid.

### Step 1-2: polymerization: carbazole-containing reaction unit polymerizing with a dimer unit.

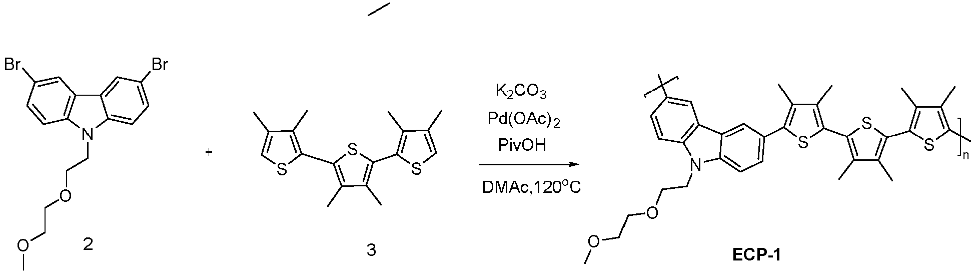

Compound 2 (1 eq), compound 3 (1 eq), K₂CO₃ (2.6 eq), PivOH(0.3 eq), Pd(OAc)₂, (0.02 eq) are added into a Schenk tube. Then vacuum(3-5min) and refill the tube with nitrogen. Repeat this procedure for three times. Subsequently, nitrogen degassed solvent Dimethylacetamide (DMAc) is added, and the mixture is heated to 120°C and last for 14 hours. Then the mixture is poured into methanol to precipitate out the crude polymer solid. Filter to get the solid and re-dissolve the solid into chloroform and wash with water for three times. The chloroform solution is added into large amount of methanol and precipitate out the polymer. The suspension is filtered to get the desired product polymer ECP-1.

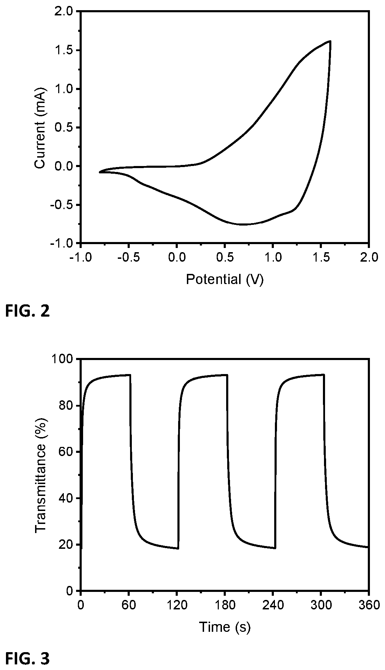

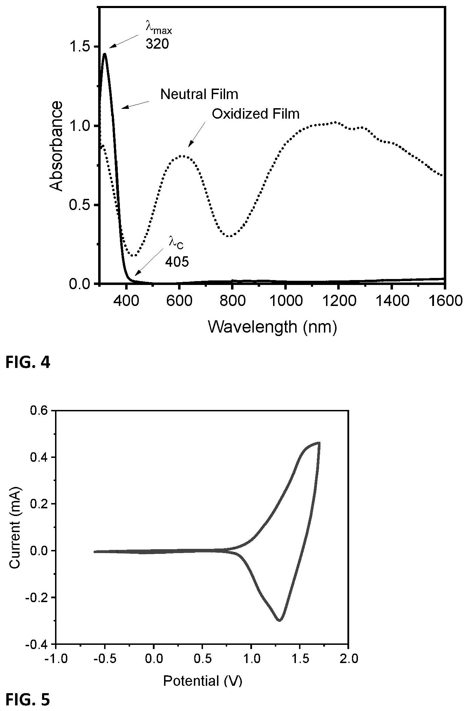

The obtained ECP-1 has an oxidation potential of around 0.75 V (vs. Ag/AgCl) and an energy bandgap of higher than 3.0 eV. The ECP-1 is fabricated into a solid-state ECD with ECP-1 used as the electrochromic layer, 0.2M of LiTFSI in PEGDA as the electrolyte, and VOx as the ion storage layer. The solid-state ECD can be stably switched between -0.5 V to 1.5 V (FIG. 2). The neutral state and oxidized absorbance spectra of the ECP-1 are shown in FIG. 4 with 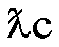 of 405 nm and 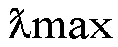 of 320 nm. The solid-state ECD shows a high transparency with transmittance as high as 93% in the neutral state (FIG. 3), and switches to a bright blue color when ECP-1 is oxidized with one absorption peak at about 614 nm and another boarder absorption band at the near-IR region, around 900-1100 nm (FIG. 4). The optical contrast of the solid-state ECD is about 75% (FIG. 3).

### Example 2 ECP-2

In some embodiments, the disclosed ECP-2 has a formula of

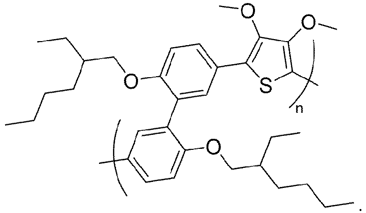

The ECP-2 is synthesized by first preparing a substituted benzene reaction unit and then polymerizing it with an acyclic dioxythiophene (AcDOT) unit. The detail method includes the following steps:

### Step 2-1: preparing a benzene-containing reaction unit (compound 4) by two steps.

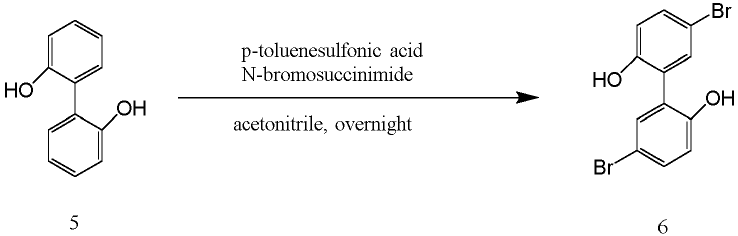

Compound 5 and p-toluenesulfonic acid are dissolved in acetonitrile. Subsequently, N-bromosuccinimide is added, and the mixture is agitated overnight. The suspension is filtered to get the desired product. The product compound 6 is a white solid.

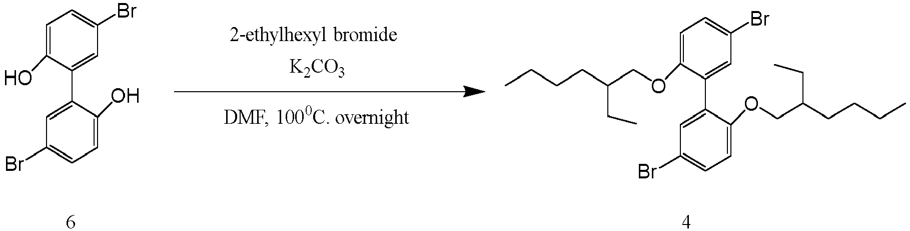

Compound 6 is dissolved in DMF under N₂. K₂CO₃ is added to the solution, and the reaction mixture is stirred for 15 mins, after which 2-ethylhexyl bromide is added. The reaction mixture is stirred at 100⁰C overnight. The reaction is stopped and cooled down to room temperature. The solvent is removed in vacuum, and the residue is dissolved in diethyl ether. The organic phase is washed with water, and the aqueous phases are extracted with ethyl acetate. The combined organic phases are dried, and the volatiles is removed by vacuum. The crude is passed through a small silica column, and the solvent is dried in vacuum to get the compound 4 as a yellow oil..

Step 2-2: polymerization: The polymerization method is similar to that in step 1-2 with the reaction units of the substituted benzene reaction unit (compound 4) and AcDOT (compound 8) with a structure of

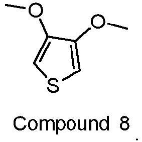

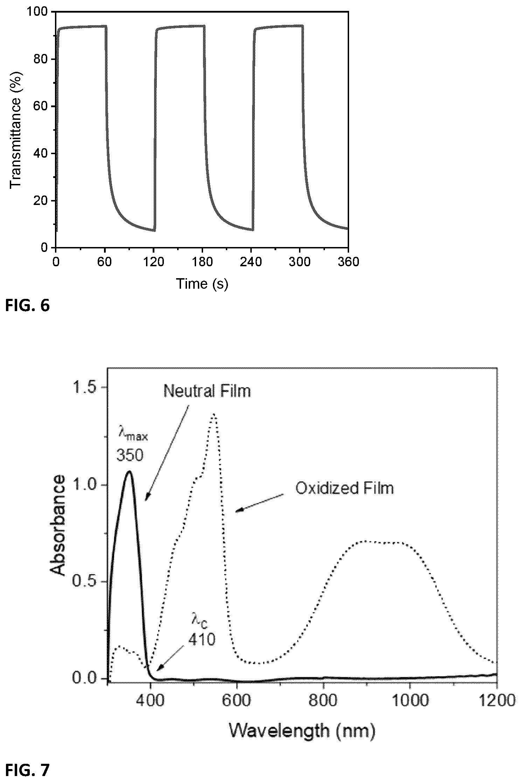

The obtained ECP-2 has a oxidation potential around 0.95 V (vs. Ag/AgCl) and an energy bandgap higher than 3.1 eV. The ECP-2 is fabricated into a solid-state ECD with ECP-2 used as the electrochromic layer, 1M of LiPF₆ in PEGMEA as the electrolyte, and VOₓ as the ion storage layer. The solid-state ECD can be stably switched between -0.6 V to 1.7 V (FIG. 5). The neutral state and oxidized state absorbance spectra of the ECP-2 are shown in FIG. 7 with 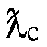 of 410 nm and 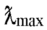 of 350 nm. The solid-state ECD shows high transparency with transmittance as high as 94% at neutral state at 550 nm (FIG. 6), and switches to bright red color when ECP-2 is oxidized with one absorption peak at around 546 nm and another broader absorption band at the wavelength around 800-1100 nm (FIG. 7). The optical contrast of the solid-state ECD is 87% (FIG. 6).

### Example 3 ECP-3

In some embodiments, the disclosed ECP-3 has a formula of

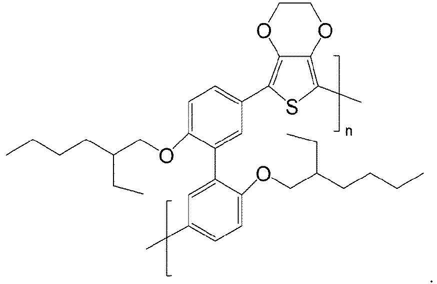

ECP-3 is synthesized by preparing a benzene-containing reaction unit and polymerizing it with a ProDot unit. The detail method includes the following steps:

### Step 3-1: the same as Step 2-1

Step 3-2: polymerization: The polymerization method is similar to that in step 1-2 with the different reaction units of benzene-containing reaction unit (compound 4) and 3, 4-Ethylenedioxythiophene (EDOT, compound 9) with a structure of

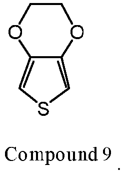

### Example 4 ECP -4

In some embodiments, the disclosed ECP-4 has a formula of

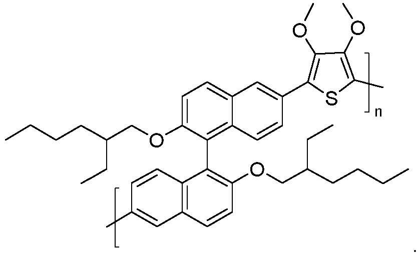

The ECP-4 is synthesized by preparing a naphthalene-containing reaction unit and then polymerizing it with an AcDOT unit. The detail method includes the following steps:

### Step 4-1: preparing naphthalene-containing reaction unit (compound 10) by two steps.

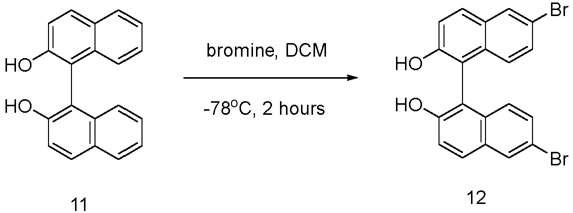

To a solution of compound 11 in dichloromethane was added dropwise a solution of bromine in dichloromethane over 15 minutes at -78°C. The reaction mixture is stirred for 2 hours at -78⁰C and then warmed gradually to room temperature and stay at room temperature for an additional 2 hours. The excess bromine was quenched by saturated aqueous sodium sulfite solution and stirred for 2 hours at room temperature. After extraction with dichloromethane, the combined organic layer was washed with brine, dried over sodium sulfate, and concentrated in vacuum.

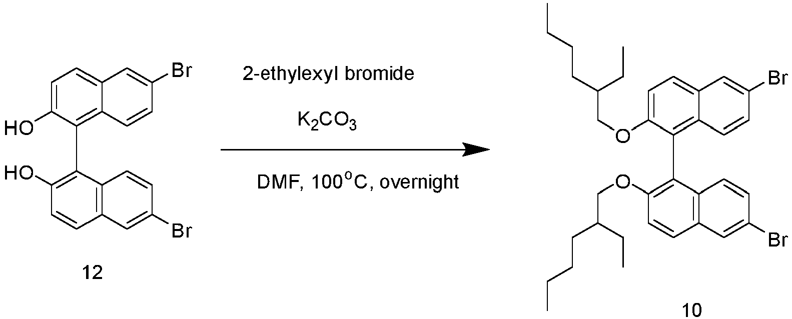

Compound 12 is dissolved in DMF under N₂, K₂CO₃ is added to the solution, and the reaction mixture is stirred for 15 minutes, after which 2-ethylexyl bromide is added. The reaction mixture is stirred at 100⁰C overnight. The reaction is stopped and cooled down to room temperature. The solvent is removed in vacuum, and the residue is dissolved in diethyl ether. The organic phase is washed with water, and the aqueous phases are extracted with ethyl acetate. The combined organic phases are dried by vacuum.

Step 4-2: polymerization: The polymerization method is similar to that in step 1-2 with the different reaction units of the naphthalene-containing reaction unit (compound 10) and AcDOT (compound 8).

### Example 5 ECP-5

In some embodiments, the disclosed ECP-5 has a formula of

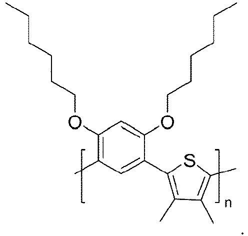

The ECP-5 is synthesized by a similar polymerization method to that in step 1-2 with the different reaction units of 1,5-dibromo-2,4-bis(hexyloxy)benzene and 3,4-dimethylthiophene.

In some embodiments, the disclosed ECP has a formula of 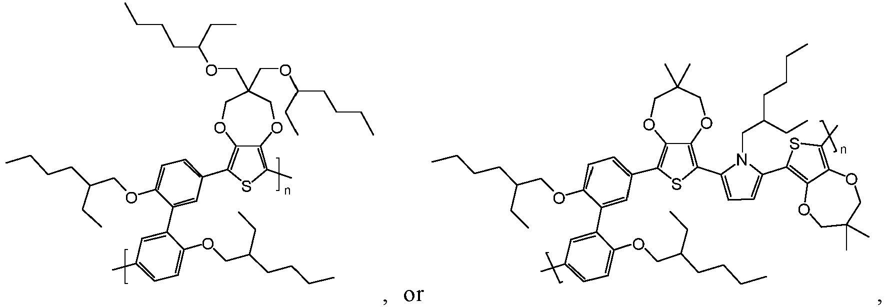 or 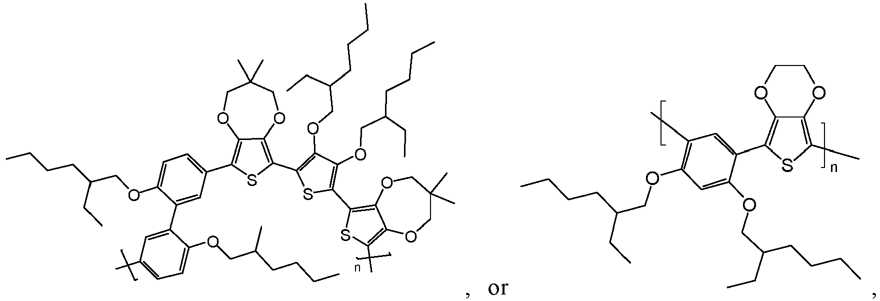 or 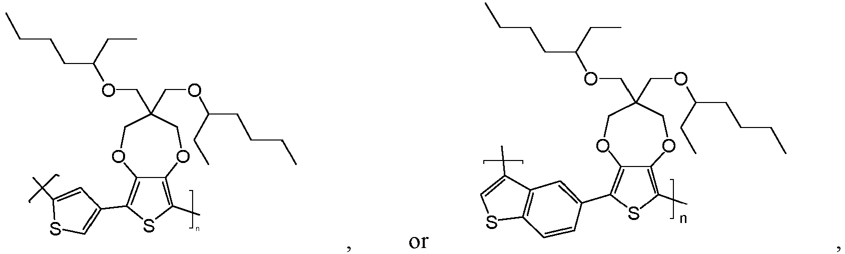 or 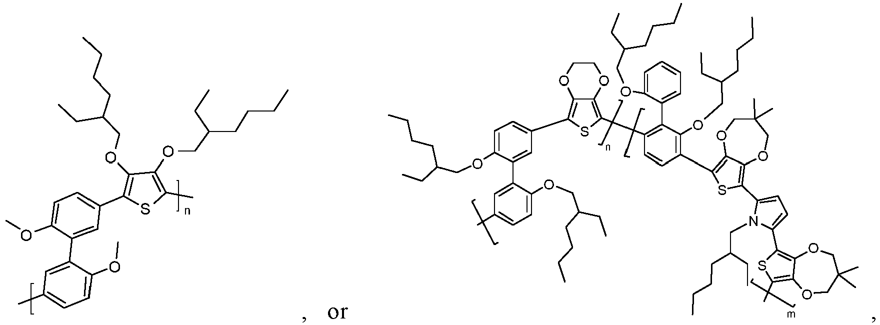 or 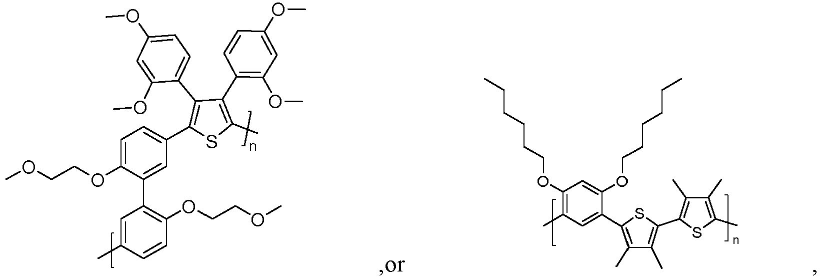 or 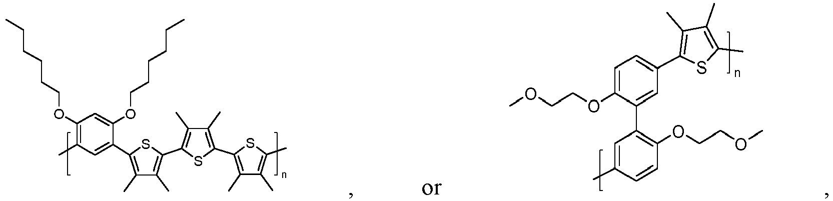 or 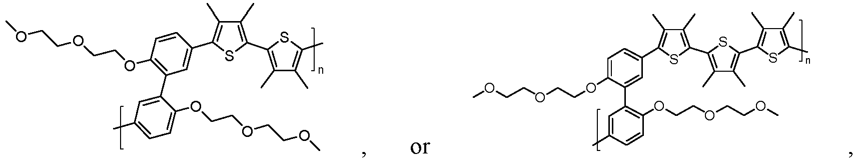 or 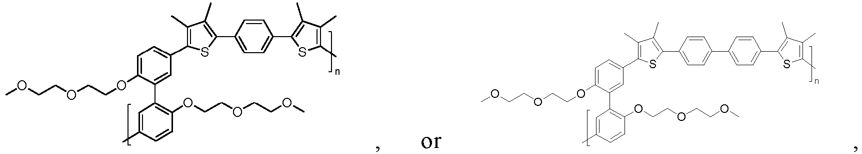 or 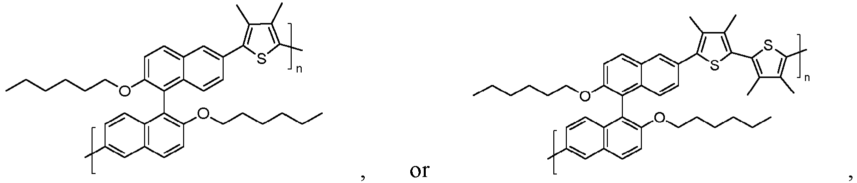 or 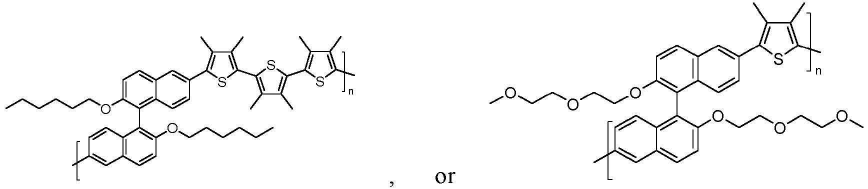 or 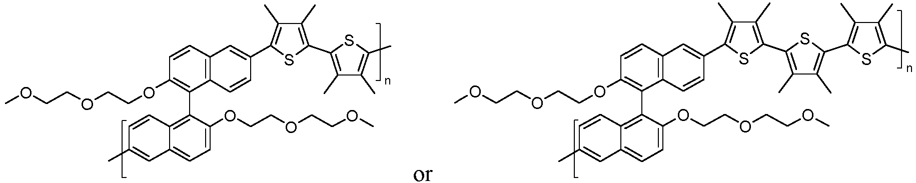 or 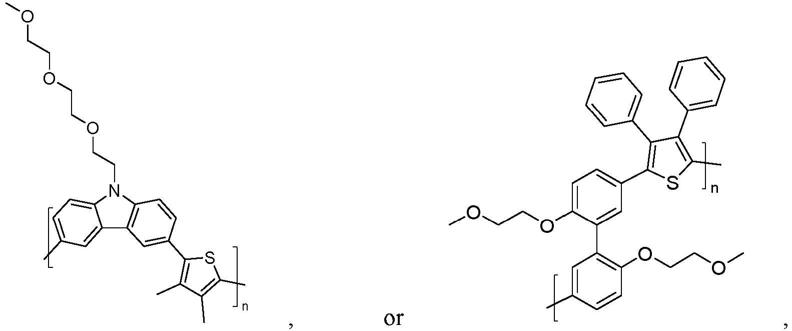 or 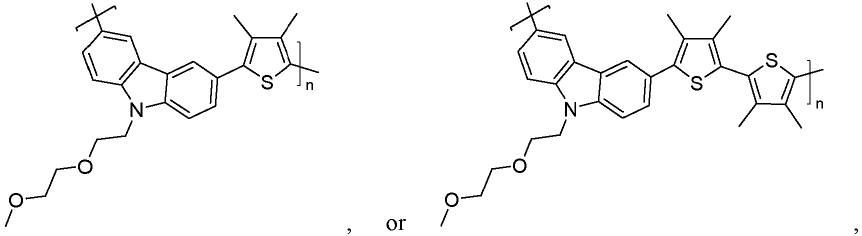 or 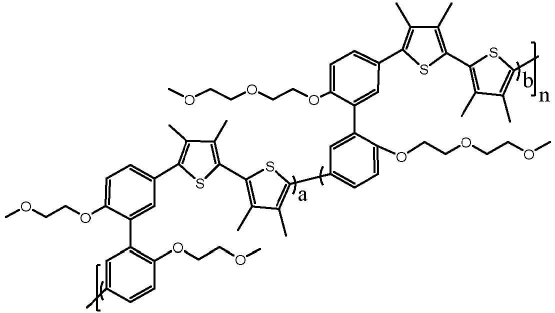 wherein n and m are integers greater than 0, a and b are integers equal to or greater than 0 with at least one of a and b is greater than 0.

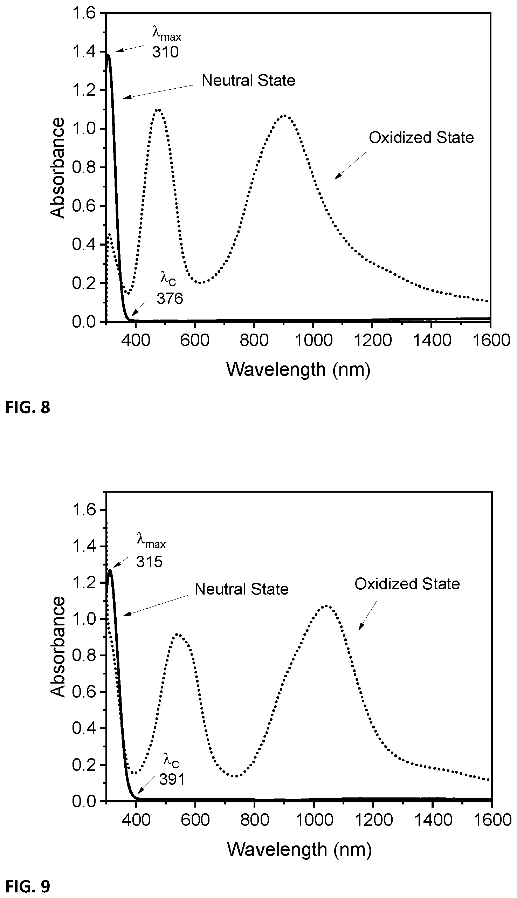

In some embodiments, the disclosed ECP has an absorption onset less than 400nm. In one embodiment, the ECP-6 solution with the formula of 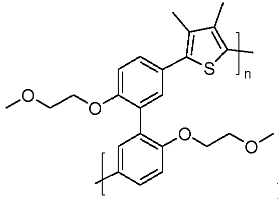 has 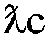 of 376 nm as shown in FIG. 8. In one embodiment, the ECP-7 solution with the formula of 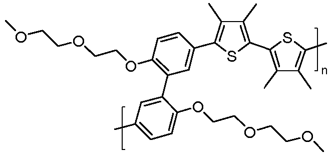 has 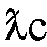 of 391 nm as shown in FIG. 9. Both ECP-6 and ECP-7 were made into thin films and presented similar absorption spectra as the ones in solution.

In another aspect, the disclosed polymers can have fluorescent emission and can be applied to fluorescent products.

The foregoing description of the present disclosure has been provided for the purposes of illustration and description. It is not intended to be exhaustive or to limit the disclosure to the precise forms disclosed. The breadth and scope of the present disclosure should not be limited by any of the above-described exemplary embodiments. Many modifications and variations will be apparent to the practitioner skilled in the art. The embodiments were chosen and described in order to best explain the principles of the disclosure and its practical application, thereby enabling others skilled in the art to understand the disclosure for various embodiments and with various modifications that are suited to the particular use contemplated. It is intended that the scope of the disclosure be defined by the following claims.

## Claims

1. An electrochromic polymer, comprising :
a repeat unit comprising one or more meta-conjugated linkers (MCLs) and one or more aromatic moieties (Ars),
wherein each of the one or more MCLs is partially conjugated with the one or more Ars at meta positions of the one or more MCLs to form a polymer backbone of the electrochromic polymer,
wherein each of the one or more MCLs and corresponding meta positions comprise one of the following formulas: 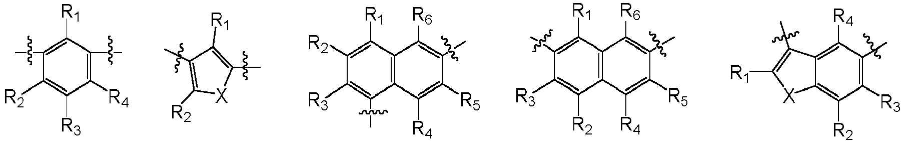 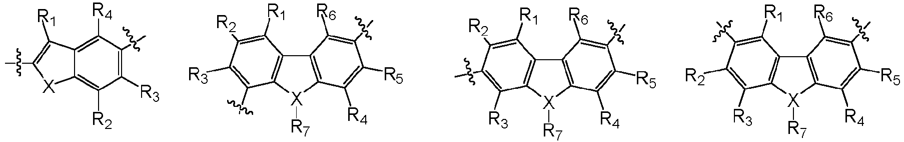 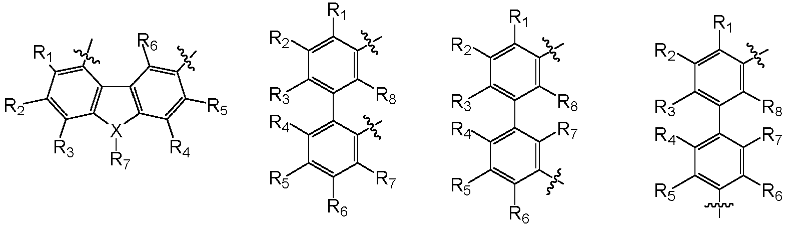 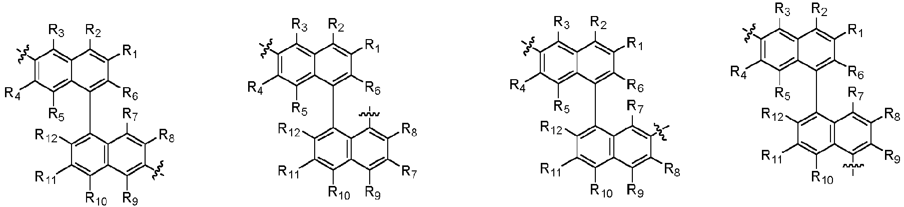 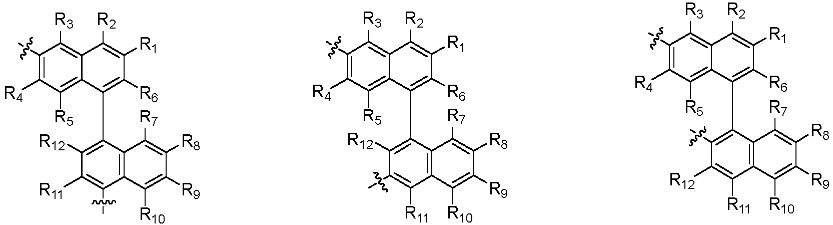 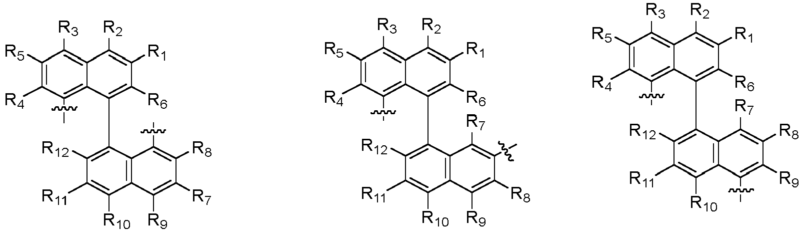 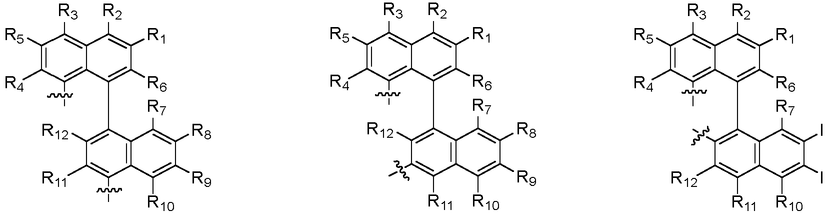 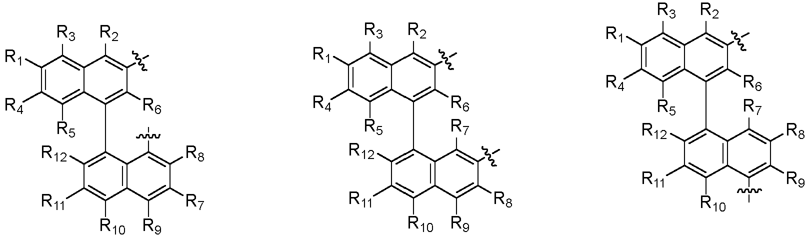 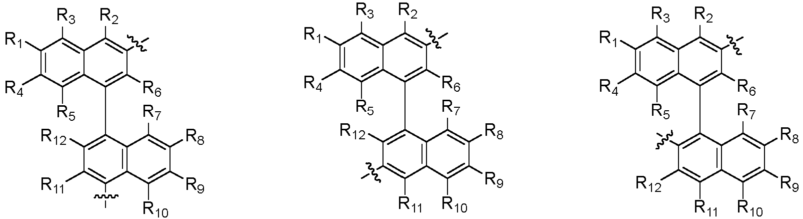 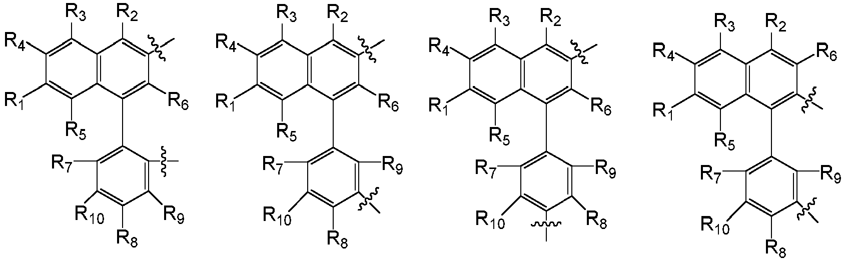 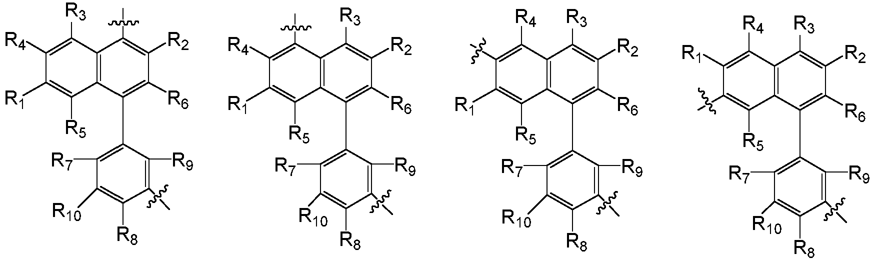 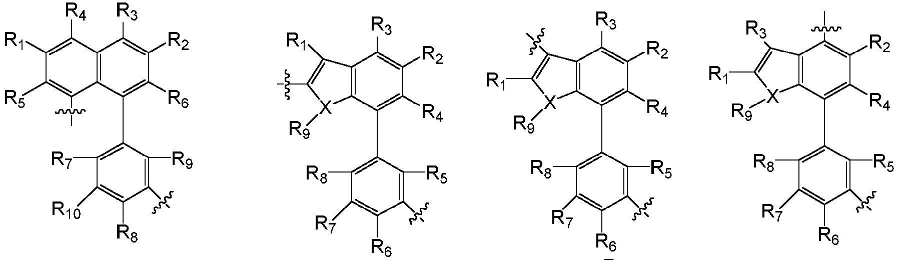 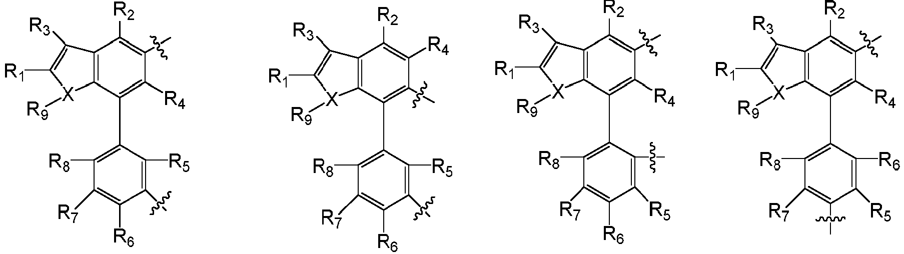 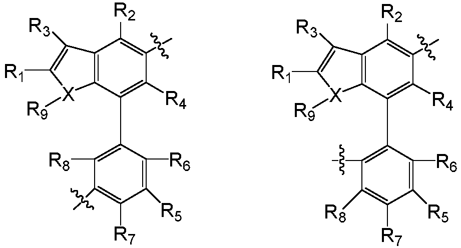 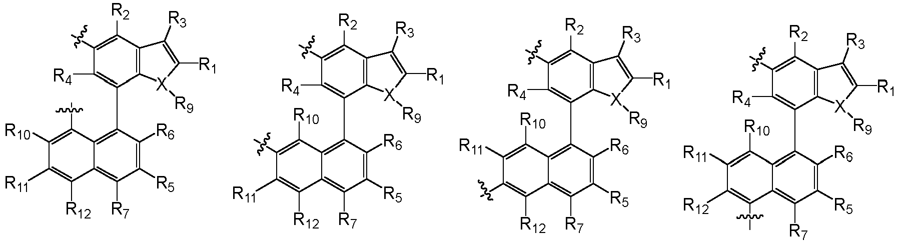 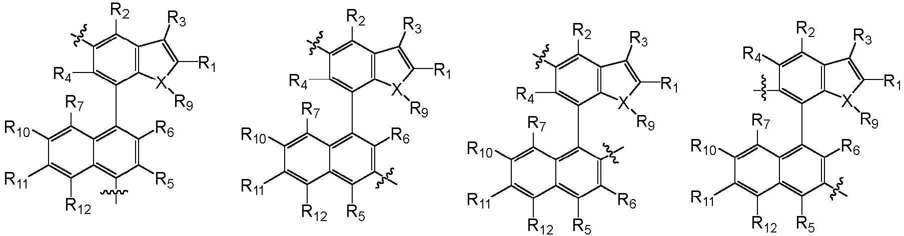 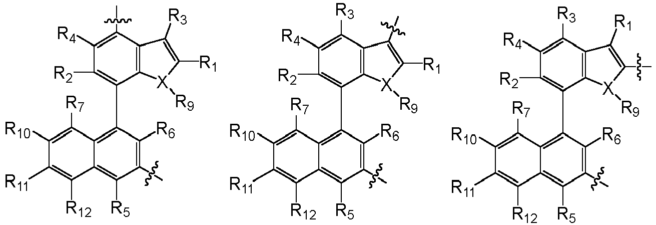 wherein X is S, Se, N, C, or O; each of R₁-R₁₂ is independently selected from one of hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀ aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, Cs-C₃₀ cycloalkylalkylaminyl, C₅-C₃₀ cycloalkylalkyl, C₅-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl; and each of the wavy lines represents one of the meta positions,
wherein each of the one or more Ars comprises one of a thiophene-based unit, a furan-based unit, a selenophene-based unit, or a pyrrole-based unit with one of the following formulas: 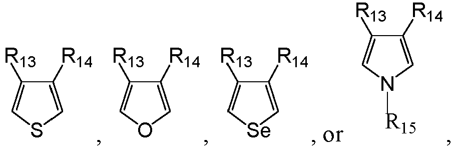 wherein each of R₁₃ R₁₄ and R₁₅ is independently selected from one of hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀ aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl, C₅-C₃₀ cycloalkylalkyl, C₅-C₃₀ cycloalkylalkyloxy, C₁-C₁₂ heterocyclyl, C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl, and
wherein the electrochromic polymer is colorless in the neutral state, or wherein the electrochromic polymer has an absorption onset equal to or smaller than 420 nm in a neutral state.

2. The electrochromic polymer of claim 1, wherein the electrochromic polymer has an absorption maximum ( 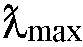 ) smaller than 410 nm in the neutral state.

3. The electrochromic polymer of claim 1, wherein the electrochromic polymer has absorption in visible and/or near-infrared wavelengths in an oxidized state.

4. The electrochromic polymer of claim 4, wherein the electrochromic polymer has an absorption coefficient larger than 10⁴ cm⁻¹ in the oxidized state.

5. The electrochromic polymer of claim 1, wherein the electrochromic polymer has an oxidation potential in the ranges of 0.1-1.5 V inclusive versus Ag/AgCl electrode.

6. The electrochromic polymer of claim 1, wherein the one or more MCLs and the one or more Ars are arranged in an alternative fashion with a formula of 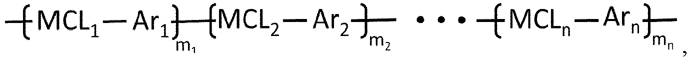 wherein n is an integer greater than 0, and each of m₁, m₂, ... , mₙ is an integer equal to or greater than 0 with at least one of m₁, m₂, ... , mₙ is greater than 0.

7. The electrochromic polymer of claim 1, wherein each of the one or more Ars comprises a thiophene-based unit, wherein the thiophene-based unit comprises one of the following formulas: 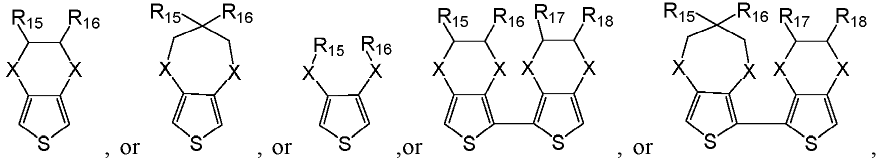 or 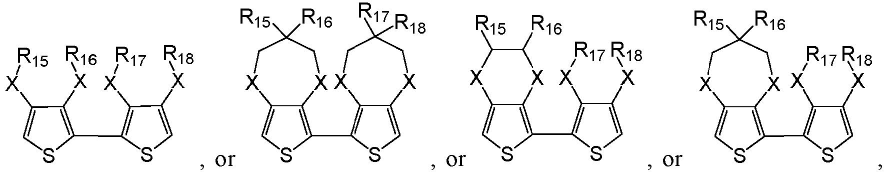 or 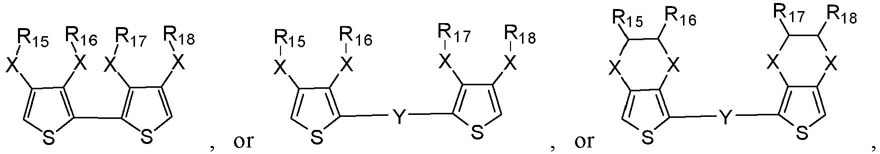 or 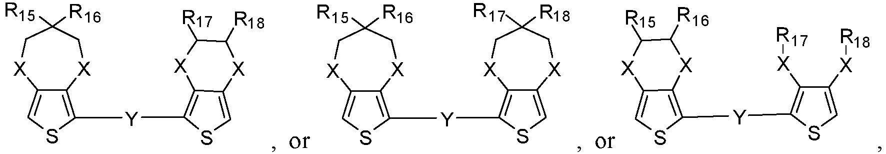 or 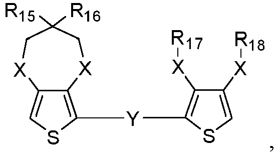 wherein X is S, Se, N, C, or O; each of R₁₅ - R₁₈ is independently selected from one of hydrogen, C₁-C₃₀ alkyl, C₂-C₃₀ alkenyl, C₂-C₃₀ alkynyl, C₂-C₃₀ alkylcarbonyl, C₁-C₃₀ alkoxy, C₃-C₃₀ alkoxyalkyl, C₂-C₃₀ alkoxycarbonyl, C₄-C₃₀ alkoxycarbonylalkyl, C₁-C₃₀ alkylthio, C₁-C₃₀ aminylcarbonyl, C₄-C₃₀ aminylalkyl, C₁-C₃₀ alkylaminyl, C₁-C₃₀ alkylsulfonyl, C₃-C₃₀ alkylsulfonylalkyl, C₆-C₁₈ aryl, C₃-C₁₅ cycloalkyl, C₃-C₃₀ cycloalkylaminyl, C₅-C₃₀ cycloalkylalkylaminyl**,** C₅-C₃₀ cycloalkylalkyl, C₅-C₃₀ cycloalkylalkyloxy, C₁-C₁₂ heterocyclyl**,** C₁-C₁₂ heterocyclyloxy, C₁-C₃₀ heterocyclylalkyloxy, C₁-C₃₀ heterocyclylaminyl, C₅-C₃₀ heterocyclylalkylaminyl, C₂-C₁₂ heterocyclylcarbonyl, C₃-C₃₀ heterocyclylalkyl, C₁-C₁₃ heteroaryl, or C₃-C₃₀ heteroarylalkyl; Y is any one or more of Ars, or aromatic structures, or fused aromatic structures, or a combinations thereof.

8. The electrochromic polymer of claim 7, wherein X in the thiophene-based unit is O.

9. The electrochromic polymer of claim 1, wherein the electrochromic polymer comprises a formula of: 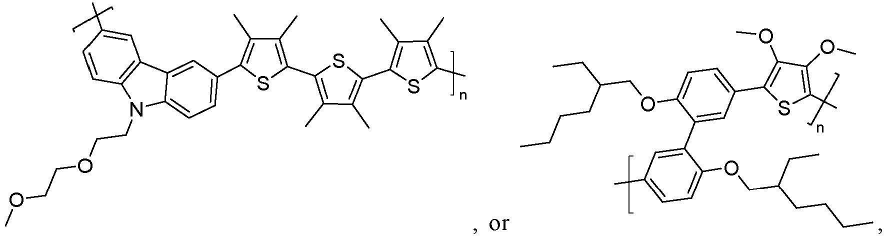 or 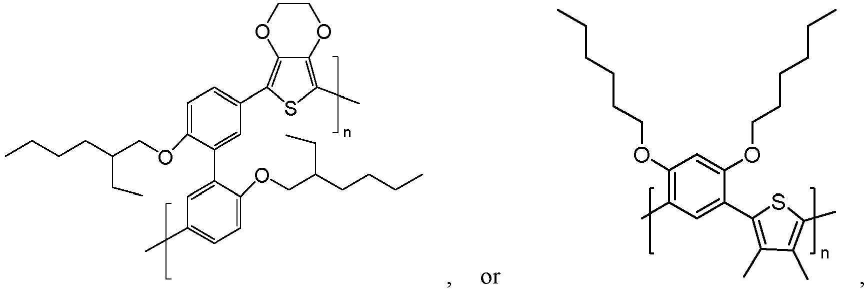 or 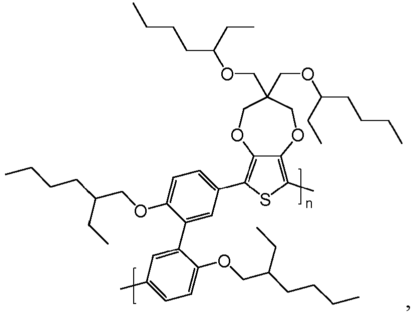 or 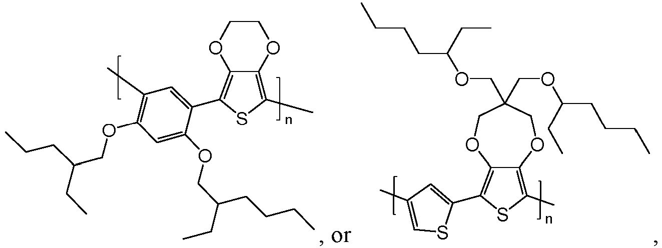 or 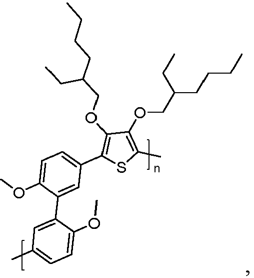 or 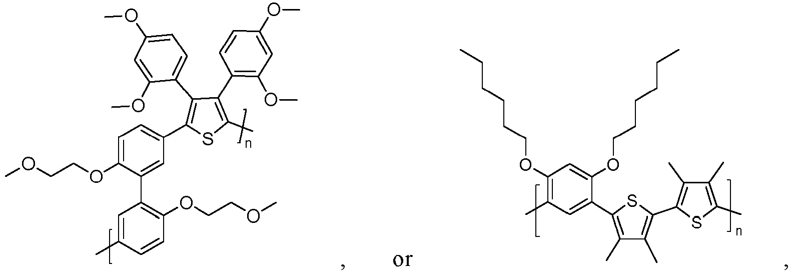 or 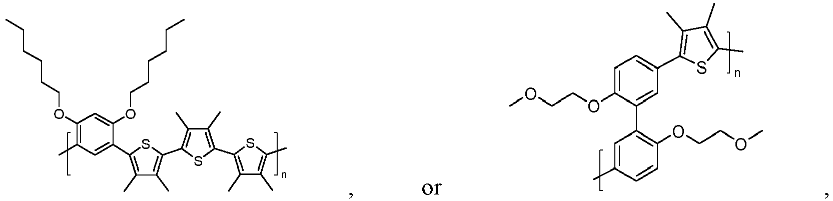 or 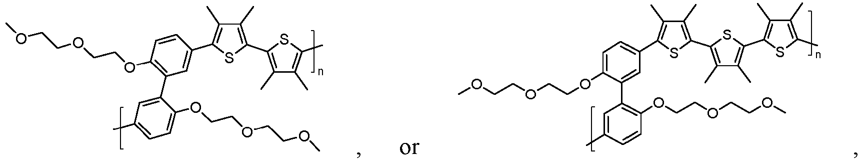 or 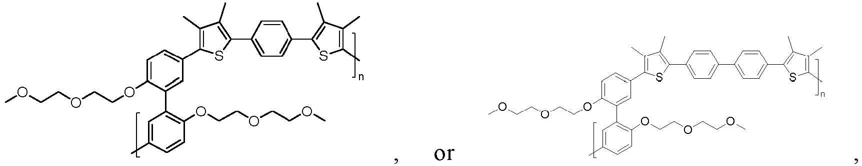 or 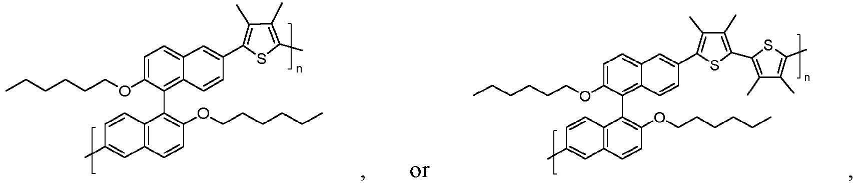 or 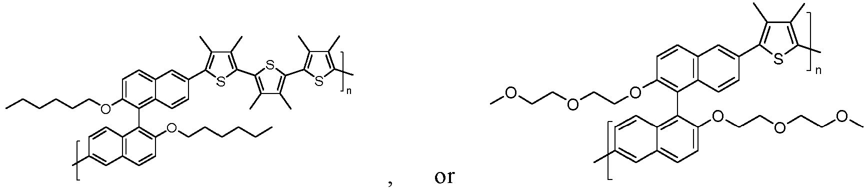 or 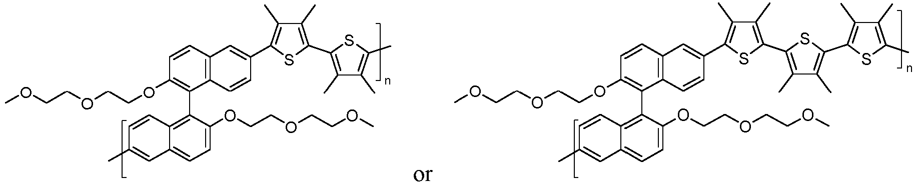 or 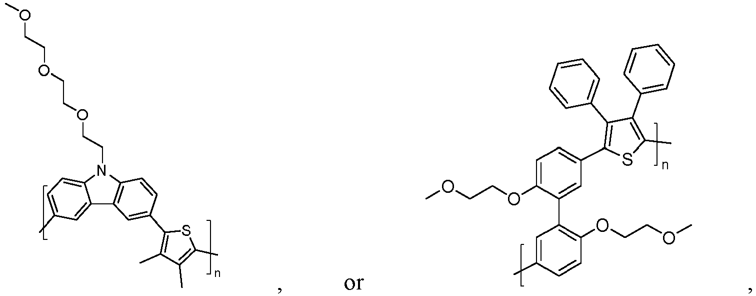 or 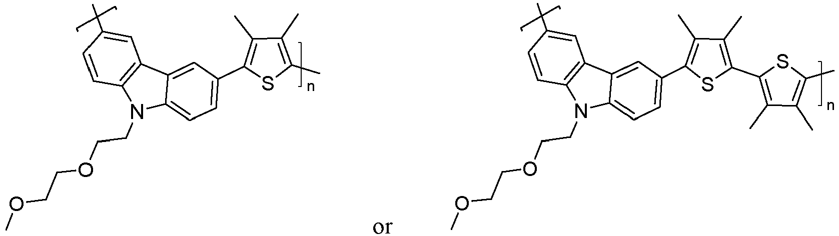 or 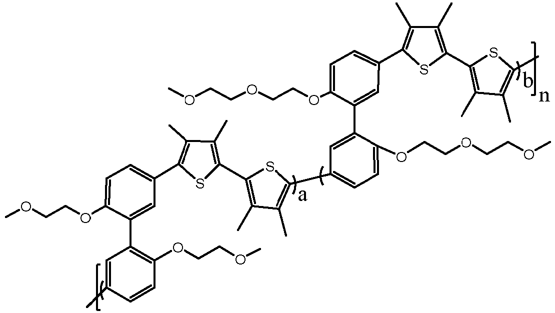 wherein n and m are integers greater than 0, a and b are integers equal to or greater than 0 with at least one of a and b is greater than 0.

## Patentansprüche

1. Elektrochromes Polymer, umfassend:
eine Wiederholungseinheit, umfassend einen oder mehrere meta-konjugierte Linker (MCLs) und eine oder mehrere aromatische Einheiten (Ars),
wobei jeder der einen oder mehreren MCLs teilweise mit dem einen oder den mehreren Ars an meta-Positionen des einen oder der mehreren MCLs konjugiert ist, um ein Polymergerüst des elektrochromen Polymers zu bilden,
wobei jeder der einen oder mehreren MCLs und entsprechende meta-Positionen eine der folgenden Formeln umfassen: 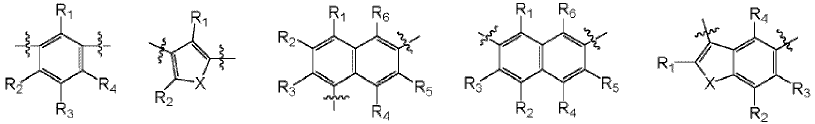 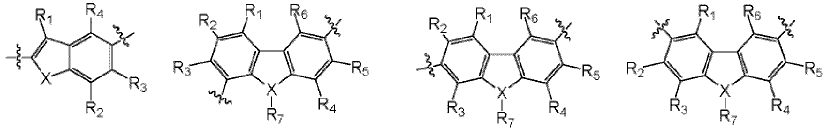 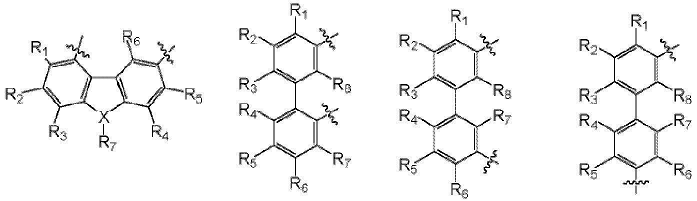 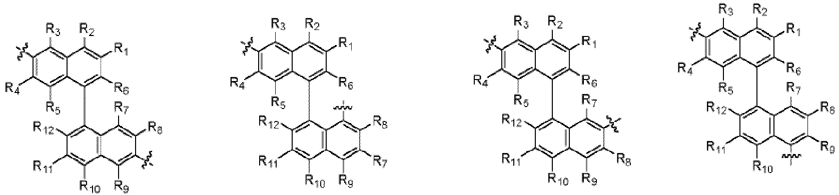 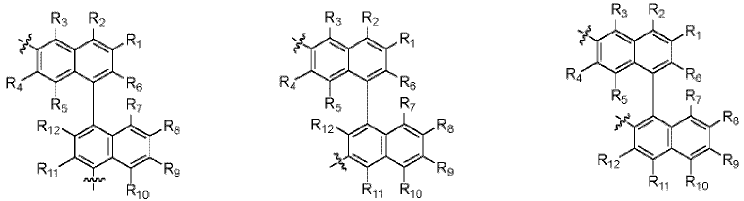 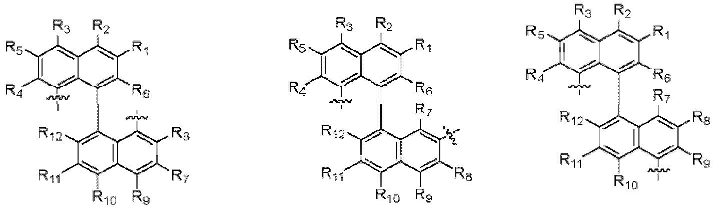 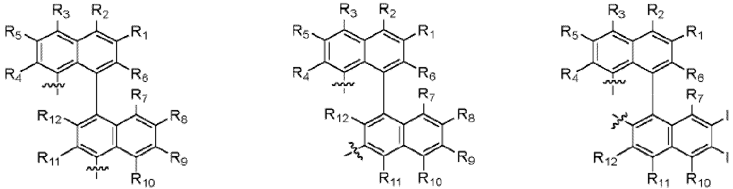 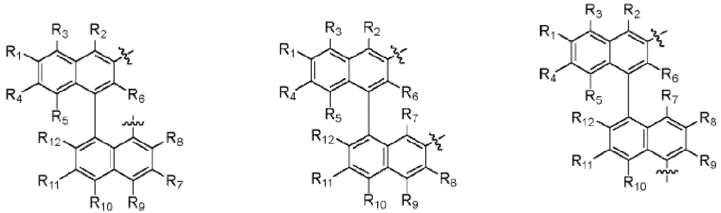 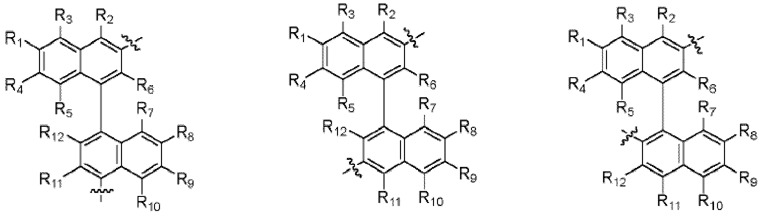 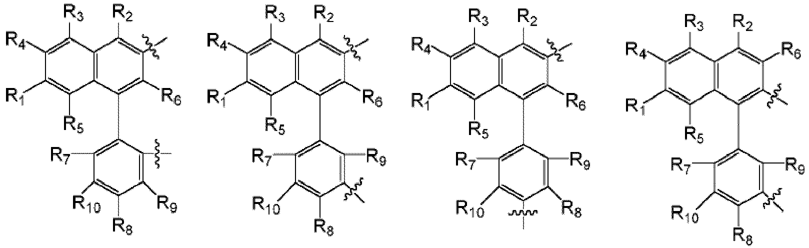 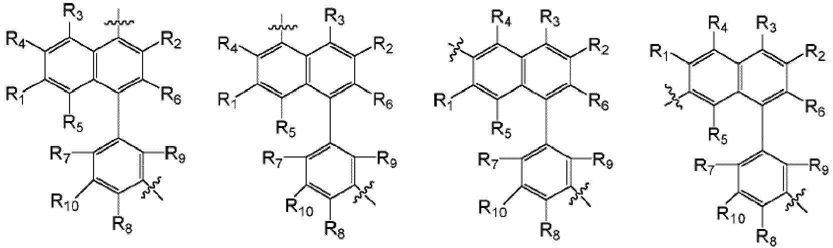 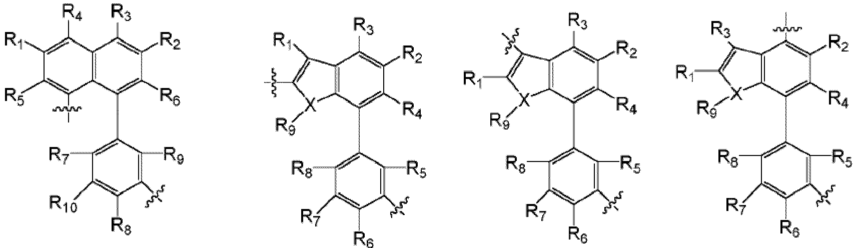 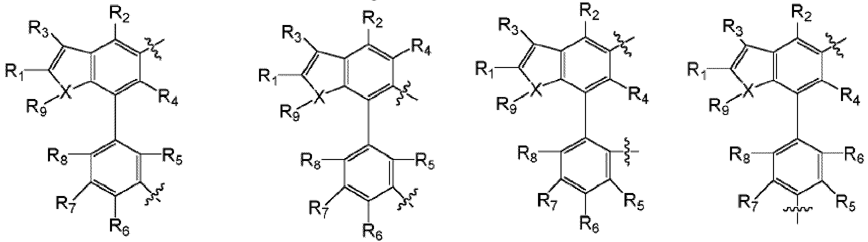 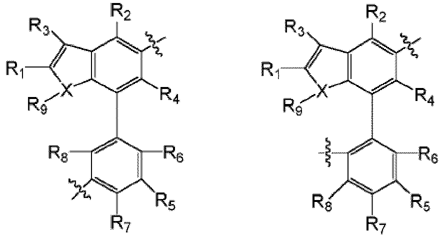 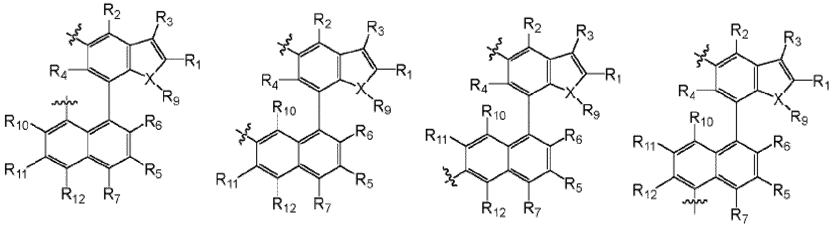 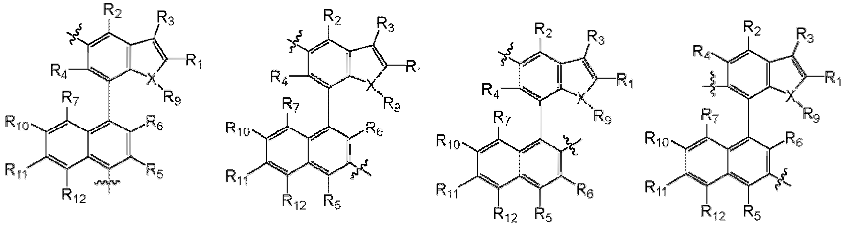 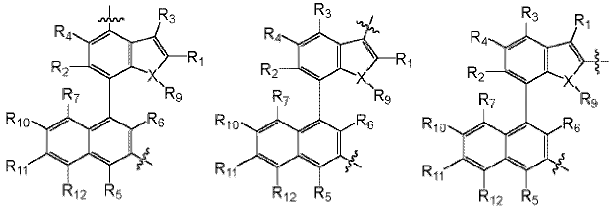
wobei X S, Se, N, C oder O ist; jedes R₁-R₁₂ unabhängig aus einem von Wasserstoff, C₁-C₃₀-Alkyl, C₂-C₃₀-Alkenyl, C₂-C₃₀-Alkinyl, C₂-C₃₀-Alkylcarbonyl, C₁-C₃₀-Alkoxy, C₃-C₃₀-Alkoxyalkyl, C₂-C₃₀-Alkoxycarbonyl, C₄-C₃₀-Alkoxycarbonylalkyl, C₁-C₃₀-Alkylthio, C₁-C₃₀-Aminylcarbonyl, C₄-C₃₀-Aminylalkyl, C₁-C₃₀-Alkylaminyl, C₁-C₃₀-Alkylsulfonyl, C₃-C₃₀-Alkylsulfonylalkyl, C₆-C₈-Aryl, C₃-C₁₅-Cycloalkyl, C₃-C₃₀-Cycloalkylaminyl, C₅-C₃₀-Cycloalkylalkylaminyl, C₅-C₃₀-Cycloalkylalkyl, C₅-C₃₀-Cycloalkylalkyloxy, C₁-C₁₂-Heterocyclyl, C₁-C₁₂-Heterocyclyloxy, C₁-C₃₀-Heterocyclylalkyloxy, C₁-C₃₀-Heterocyclylaminyl, C₅-C₃₀-Heterocyclylalkylaminyl, C₂-C₁₂-Heterocyclylcarbonyl, C₃-C₃₀-Heterocyclylalkyl, C₁-C₃₀-Heteroaryl oder C₃-C₃₀-Heteroarylalkyl ausgewählt ist; und jede der Wellenlinien eine der meta-Positionen darstellt,
wobei jede der ein oder mehreren Ars eine Einheit auf Thiophenbasis, eine Einheit auf Furanbasis, eine Einheit auf Selenophenbasis oder eine Einheit auf Pyrrolbasis mit einer der folgenden Formeln umfasst: 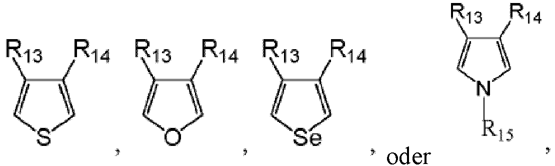
wobei jedes von R₁₃, R₁₄ und R₁₅ unabhängig aus einem von Wasserstoff, C₁-C₃₀-Alkyl, C₂-C₃₀-Alkenyl, C₂-C₃₀-Alkinyl, C₂-C₃₀-Alkylcarbonyl, C₁-C₃₀-Alkoxy, C₃-C₃₀-Alkoxyalkyl, C₂-C₃₀-Alkoxycarbonyl, C₄-C₃₀-Alkoxycarbonylalkyl, C₁-C₃₀-Alkylthio, C₁-C₃₀-Aminylcarbonyl, C₄-C₃₀-Aminylalkyl, C₁-C₃₀-Alkylaminyl, C₁-C₃₀-Alkylsulfonyl, C₃-C₃₀-Alkylsulfonylalkyl, C₆-C₁₈-Aryl, C₃-C₁₅-Cycloalkyl, C₃-C₃₀-Cycloalkylaminyl, C₅-C₃₀-Cycloalkylalkylaminyl, C₅-C₃₀-Cycloalkylalkyl, C₅-C₃₀-Cycloalkylalkyloxy, C₁-C₁₂-Heterocyclyl, C₁-C₁₂-Heterocyclyloxy, C₁-C₃₀-Heterocyclylalkyloxy, C₁-C₃₀-Heterocyclylaminyl, C₅-C₃₀-Heterocyclylalkylaminyl, C₂-C₁₂-Heterocyclylcarbonyl, C₃-C₃₀-Heterocyclylalkyl, C₁-C₁₃-Heteroaryl oder C₃-C₃₀-Heteroarylalkyl ausgewählt ist, und
wobei das elektrochrome Polymer im neutralen Zustand farblos ist oder wobei das elektrochrome Polymer im neutralen Zustand einen Absorptionsbeginn von gleich oder kleiner als 420 nm aufweist.

2. Elektrochromes Polymer nach Anspruch 1, wobei das elektrochrome Polymer im neutralen Zustand ein Absorptionsmaximum ( 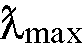 ) von kleiner als 410 nm aufweist.

3. Elektrochromes Polymer nach Anspruch 1, wobei das elektrochrome Polymer in einem oxidierten Zustand eine Absorption bei Wellenlängen im sichtbaren und/oder nahen Infrarotbereich aufweist.

4. Elektrochromes Polymer nach Anspruch 4, wobei das elektrochrome Polymer im oxidierten Zustand einen Absorptionskoeffizienten von mehr als 10⁴ cm⁻¹ aufweist.

5. Elektrochromes Polymer nach Anspruch 1, wobei das elektrochrome Polymer ein Oxidationspotential im Bereich von einschließlich 0,1 bis 1,5 V gegenüber einer Ag/AgCl-Elektrode aufweist.

6. Elektrochromes Polymer nach Anspruch 1, wobei die eine oder mehreren MCLs und die eine oder mehreren Ars in abwechselnder Weise mit einer Formel angeordnet sind, 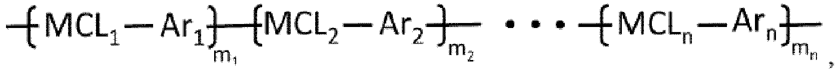 wobei n eine ganze Zahl größer als 0 ist und jedes von m₁, m₂, ..., mₙ eine ganze Zahl gleich oder größer als 0 ist, wobei mindestens eines von m₁, m₂, ..., mₙ größer als 0 ist.

7. Elektrochromes Polymer nach Anspruch 1, wobei jedes der einen oder mehreren Ars eine Einheit auf Thiophenbasis umfasst, wobei die Einheit auf Thiophenbasis eine der folgenden Formeln umfasst: 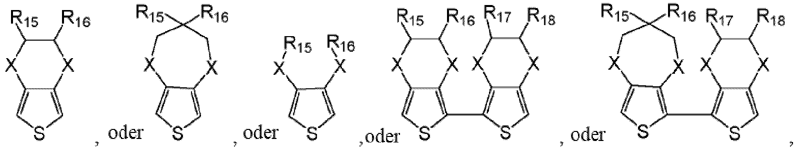 oder 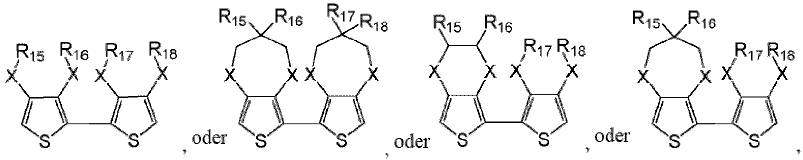 oder 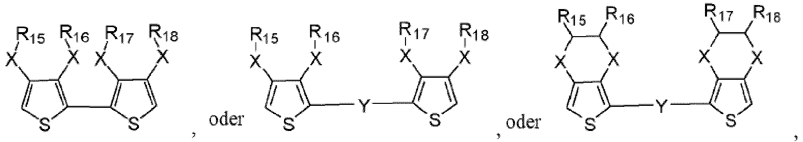 oder 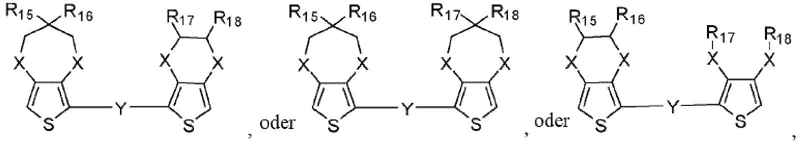 oder 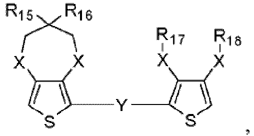 wobei X S, Se, N, C oder O ist; jedes R₁₅-R₁₈ unabhängig aus einem von Wasserstoff, C₁-C₃₀-Alkyl, C₂-C₃₀-Alkenyl, C₂-C₃₀-Alkinyl, C₂-C₃₀-Alkylcarbonyl, C₁-C₃₀-Alkoxy, C₃-C₃₀-Alkoxyalkyl, C₂-C₃₀-Alkoxycarbonyl, C₄-C₃₀-Alkoxycarbonylalkyl, C₁-C₃₀-Alkylthio, C₁-C₃₀-Aminylcarbonyl, C₄-C₃₀-Aminylalkyl, C₁-C₃₀-Alkylaminyl, C₁-C₃₀-Alkylsulfonyl, C₃-C₃₀-Alkylsulfonylalkyl, C₆-C₁₈-Aryl, C₃-C₁₅-Cycloalkyl, C₃-C₃₀-Cycloalkylaminyl, C₅-C₃₀-Cycloalkylalkylaminyl, C₅-C₃₀-Cycloalkylalkyl, C₅-C₃₀-Cycloalkylalkyloxy, C₁-C₁₂-Heterocyclyl, C₁-C₁₂-Heterocyclyloxy, C₁-C₃₀-Heterocyclylalkyloxy, C₁-C₃₀-Heterocyclylaminyl, C₅-C₃₀-Heterocyclylalkylaminyl, C₂-C₁₂-Heterocyclylcarbonyl, C₃-C₃₀-Heterocyclylalkyl, C₁-C₁₃-Heteroaryl oder C₃-C₃₀-Heteroarylalkyl ausgewählt ist; Y eine oder mehrere von Ars oder aromatischen Strukturen oder kondensierten aromatischen Strukturen oder Kombinationen davon ist.

8. Elektrochromes Polymer nach Anspruch 7, wobei X in der Einheit auf Thiophenbasis O ist.

9. Elektrochromes Polymer nach Anspruch 1, wobei das elektrochrome Polymer eine Formel umfasst von: 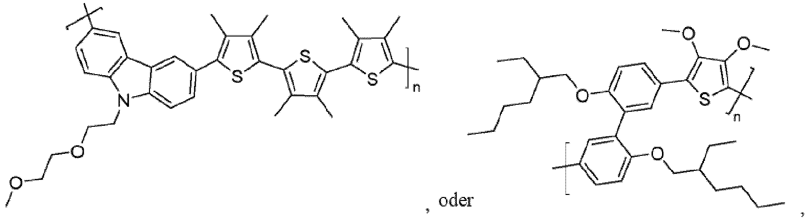 oder 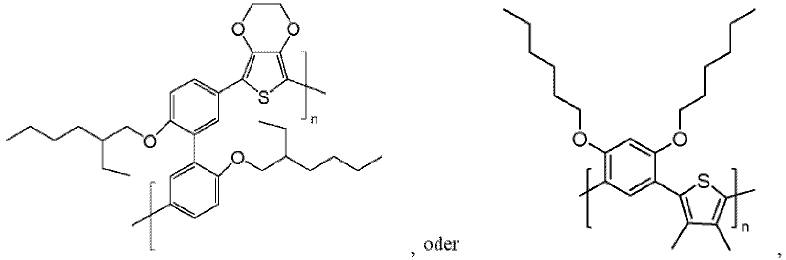 oder 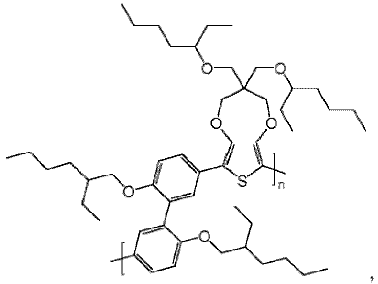 oder 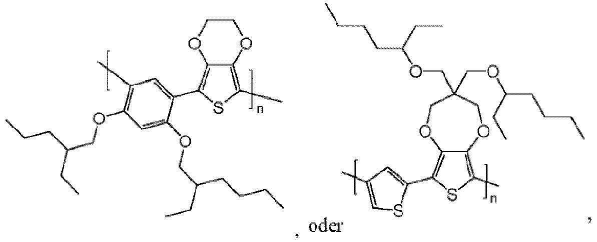 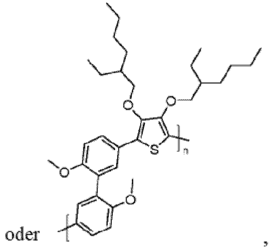 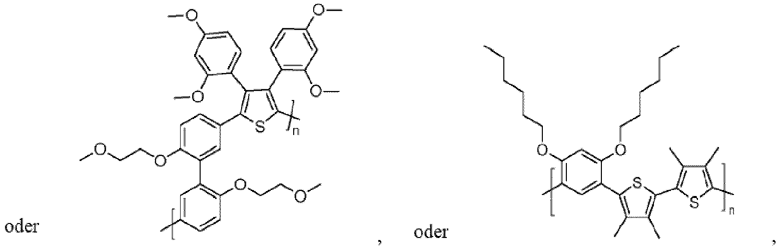 oder 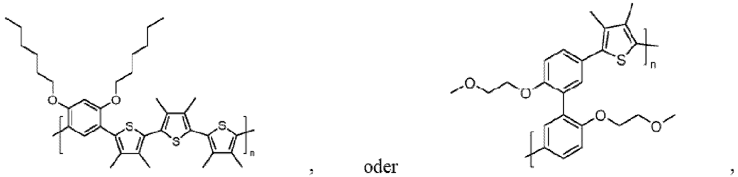 oder 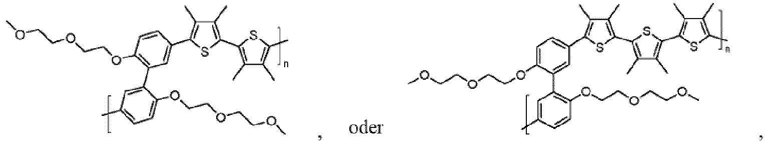 oder 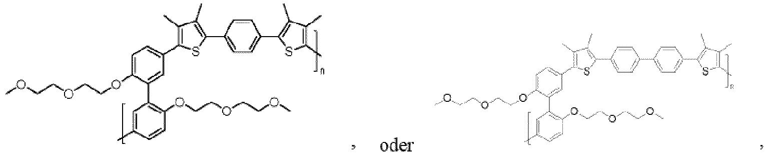 oder 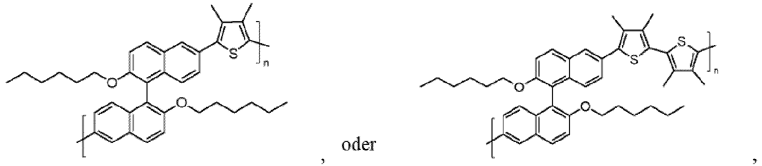 oder 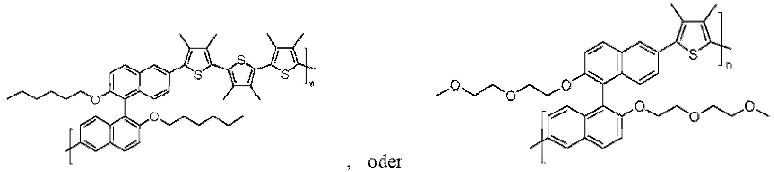 oder 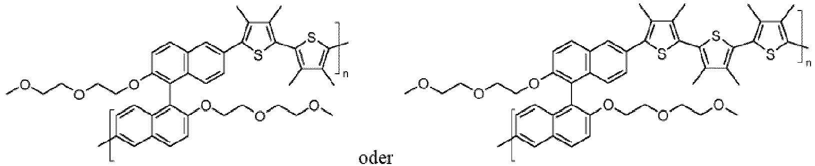 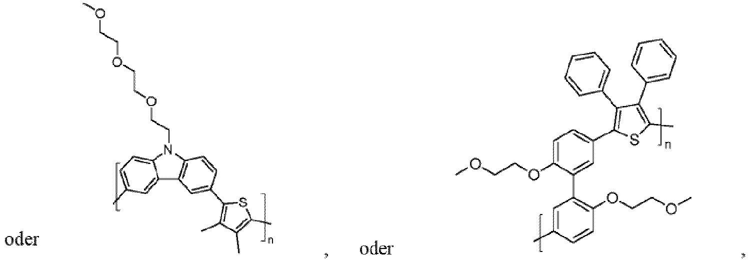 oder 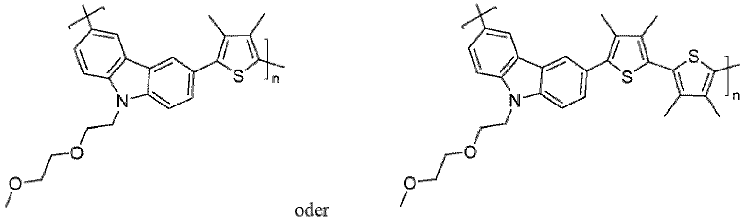 oder 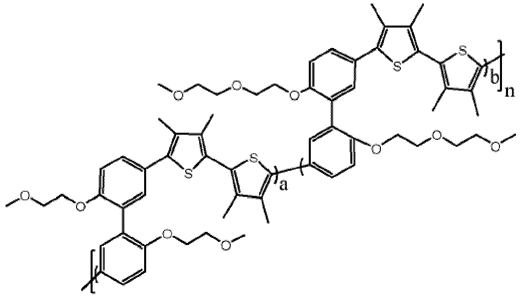 wobei n und m ganze Zahlen größer als 0 sind, a und b ganze Zahlen gleich oder größer als 0 sind, wobei mindestens eine von a und b größer als 0 ist.

## Revendications

1. Polymère électrochrome, comprenant :
une unité de répétition comprenant un ou plusieurs lieurs conjugués en méta (MCL) et une ou plusieurs fractions aromatiques (Ars),
dans lequel chacun des un ou plusieurs MCL est partiellement conjugué avec les une ou plusieurs Ars aux positions méta des un ou plusieurs MCL pour former une chaîne principale polymère du polymère électrochrome,
dans lequel chacun des un ou plusieurs MCL et les positions méta correspondantes comprennent une des formules suivantes : 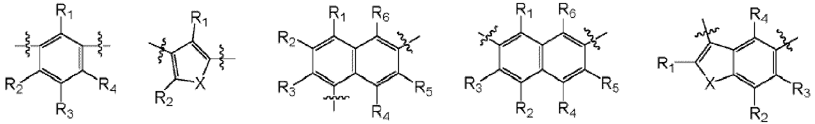 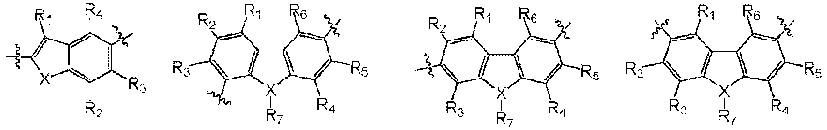 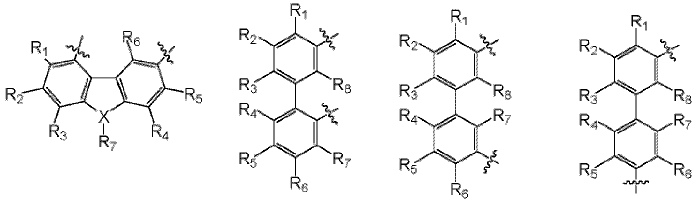 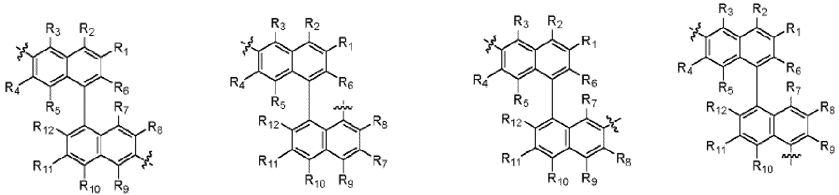 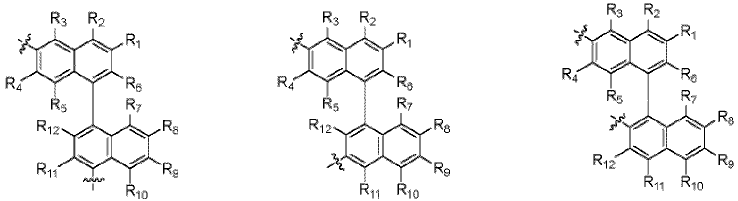 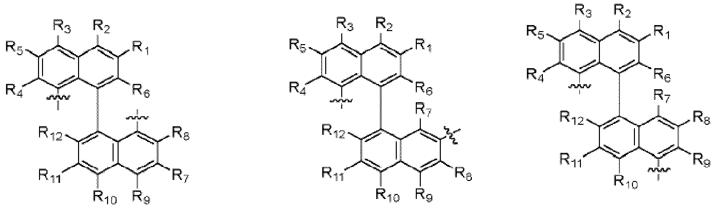 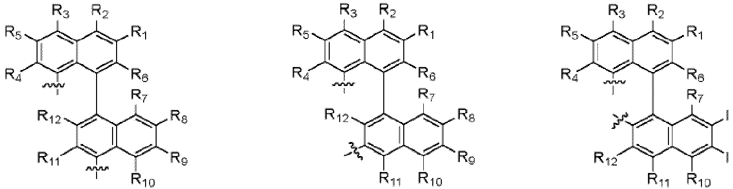 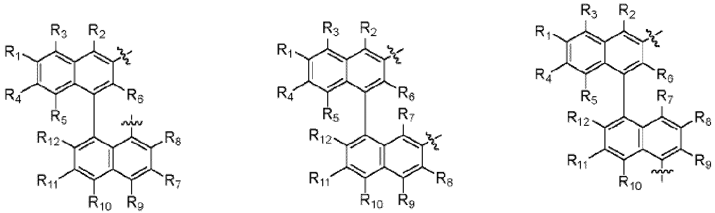 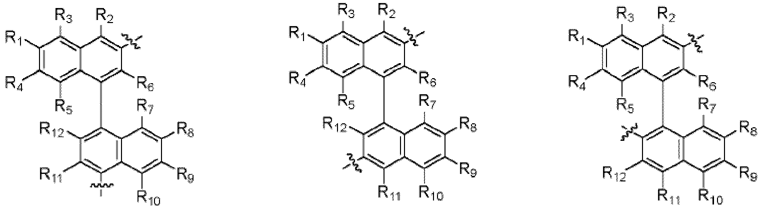 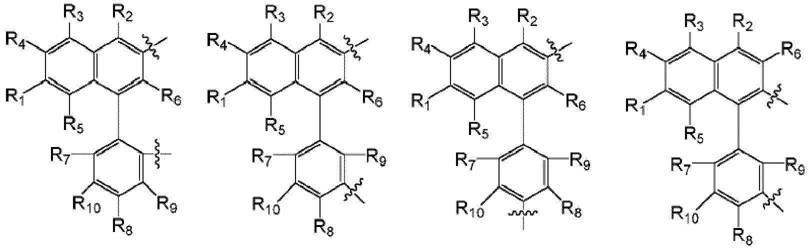 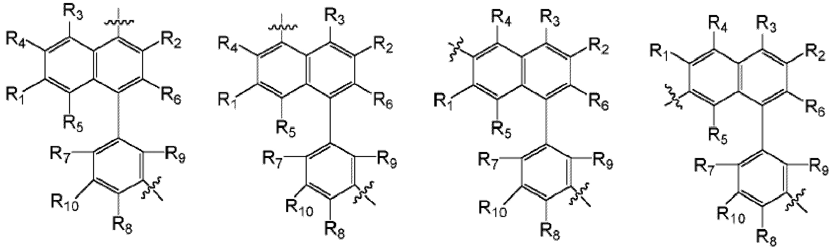 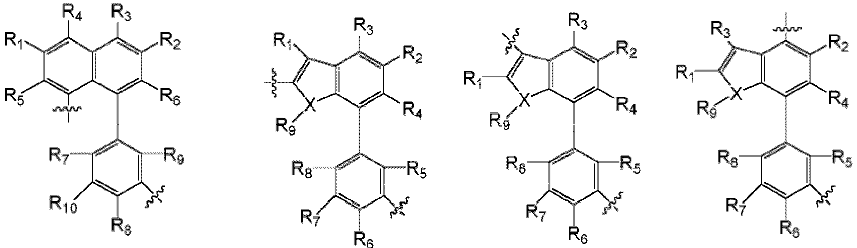 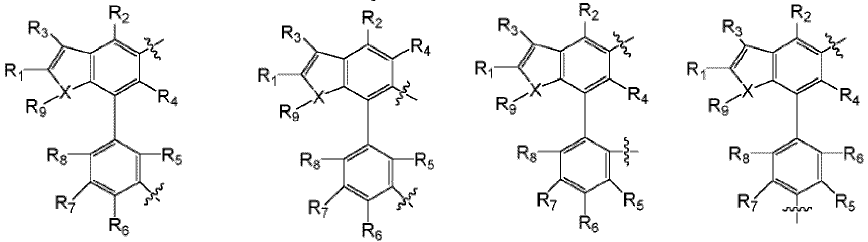 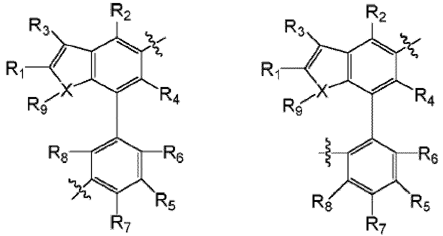 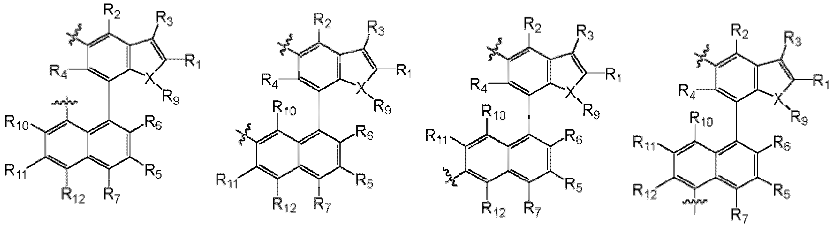 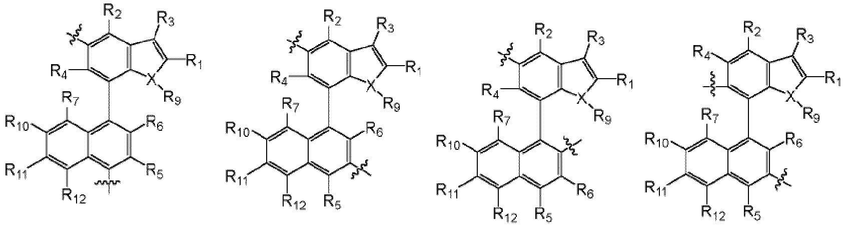 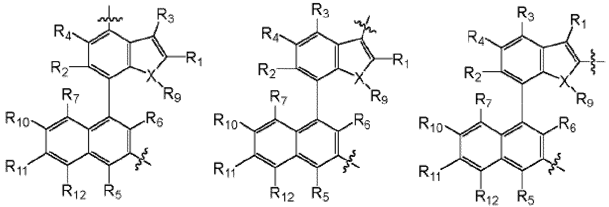
où X est S, Se, N, C ou O ; chacun des R₁-R₁₂ est indépendamment choisi parmi l'un des suivants : hydrogène, C₁-C₃₀ alkyle, C₂-C₃₀ alcényle, C₂-C₃₀ alcynyle, C₂-C₃₀ alkylcarbonyle, C₁-C₃₀ alcoxy, C₃-C₃₀ alcoxyalkyle, C₂-C₃₀ alcoxycarbonyle, C₄-C₃₀ alcoxycarbonylalkyle, C₁-C₃₀ alkylthio, C₁-C₃₀ aminylcarbonyle, C₄-C₃₀ aminylalkyle, C₁-C₃₀ alkylaminyle, C₁-C₃₀ alkylsulfonyle, C₃-C₃₀ alkylsulfonylalkyle, C₆-C₁₈ aryle, C₃-C₁₅ cycloalkyle, C₃-C₃₀ cycloalkylaminyle, C₅-C₃₀ cycloalkylalkylaminyle, C₅-C₃₀ cycloalkylalkyle, C₅-C₃₀ cycloalkylalkyloxy, C₁-C₁₂ hétérocyclyle, C₁-C₁₂ hétérocyclyloxy, C₁-C₃₀ hétérocyclylalkyloxy, C₁-C₃₀ hétérocyclylaminyle, C₅-C₃₀ hétérocyclylalkylaminyle, C₂-C₁₂ hétérocyclylcarbonyle, C₃-C₃₀ hétérocyclylalkyle, C₁-C₁₃ hétéroaryle ou C₃-C₃₀ hétéroarylalkyle ; et chacun des traits ondulés représente une des positions méta,
chacune des une ou plusieurs Ars comprenant une de : une unité à base de thiophène, une unité à base de furane, une unité à base de sélénophène ou une unité à base de pyrrole avec une des formules suivantes : 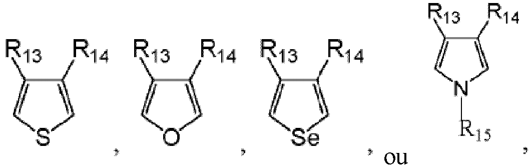
chacun des R₁₃, R₁₄ et R₁₅ étant indépendamment choisi parmi l'un des suivants : hydrogène, C₁-C₃₀ alkyle, C₂-C₃₀ alcényle, C₂-C₃₀ alcynyle, C₂-C₃₀ alkylcarbonyle, C₁-C₃₀ alcoxy, C₃-C₃₀ alcoxyalkyle, C₂-C₃₀ alcoxycarbonyle, C₄-C₃₀ alcoxycarbonylalkyle, C₁-C₃₀ alkylthio, C₁-C₃₀ aminylcarbonyle, C₄-C₃₀ aminylalkyle, C₁-C₃₀ alkylaminyle, C₁-C₃₀ alkylsulfonyle, C₃-C₃₀ alkylsulfonylalkyle, C₆-C₁₈ aryle, C₃-C₁₅ cycloalkyle, C₃-C₃₀ cycloalkylaminyle, C₅-C₃₀ cycloalkylalkylaminyle, C₅-C₃₀ cycloalkylalkyle, C₅-C₃₀ cycloalkylalkyloxy, C₁-C₁₂ hétérocyclyle, C₁-C₁₂ hétérocyclyloxy, C₁-C₃₀ hétérocyclylalkyloxy, C₁-C₃₀ hétérocyclylaminyle, C₅-C₃₀ hétérocyclylalkylaminyle, C₂-C₁₂ hétérocyclylcarbonyle, C₃-C₃₀ hétérocyclylalkyle, C₁-C₁₃ hétéroaryle ou C₃-C₃₀ hétéroarylalkyle, et
le polymère électrochrome étant incolore à l'état neutre ou le polymère électrochrome ayant un commencement d'absorption inférieur ou égal à 420 nm à l'état neutre.

2. Polymère électrochrome selon la revendication 1, où le polymère électrochrome a un maximum d'absorption ( 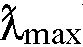 ) inférieur à 410 nm dans l'état neutre.

3. Polymère électrochrome selon la revendication 1, où le polymère électrochrome a une absorption dans les longueurs d'onde visibles et/ou proches de l'infrarouge dans un état oxydé.

4. Polymère électrochrome selon la revendication 4, où le polymère électrochrome a un coefficient d'absorption supérieur à 10⁴ cm⁻¹ à l'état oxydé.

5. Polymère électrochrome selon la revendication 1, où le polymère électrochrome a un potentiel d'oxydation dans les gammes de 0,1-1,5 V inclus vis-à-vis d'une électrode Ag/AgCl.

6. Polymère électrochrome selon la revendication 1, dans lequel les un ou plusieurs MCL et les une ou plusieurs Ars sont agencés en alternance selon une formule : 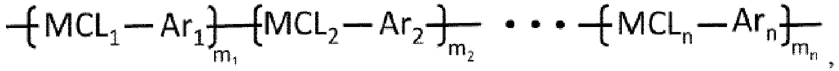 où n est un nombre entier supérieur à 0 et chacun de m₁, m₂, ..., mₙ est un nombre entier supérieur ou égal à 0 avec au moins un de m₁, m₂, ..., mₙ qui est supérieur à 0.

7. Polymère électrochrome selon la revendication 1, dans lequel chacune des une ou plusieurs Ars comprend une unité à base de thiophène, dans lequel l'unité à base de thiophène comprend une des formules suivantes : 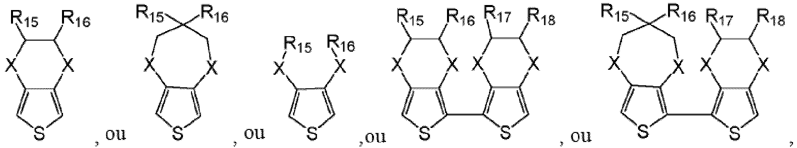 ou 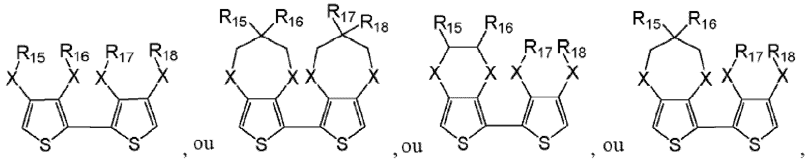 ou 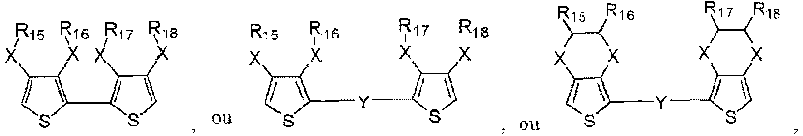 ou 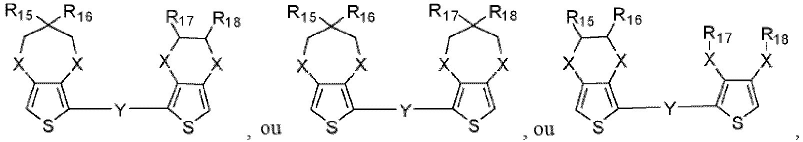 ou 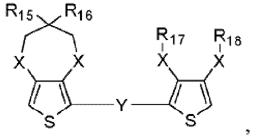 où X est S, Se, N, C ou O ; chacun de R₁₅-R₁₈ est indépendamment choisi parmi l'un des suivants : hydrogène, C₁-C₃₀ alkyle, C₂-C₃₀ alcényle, C₂-C₃₀ alcynyle, C₂-C₃₀ alkylcarbonyle, C₁-C₃₀ alcoxy, C₃-C₃₀ alcoxyalkyle, C₂-C₃₀ alcoxycarbonyle, C₄-C₃₀ alcoxycarbonylalkyle, C₁-C₃₀ alkylthio, C₁-C₃₀ aminylcarbonyle, C₄-C₃₀ aminylalkyle, C₁-C₃₀ alkylaminyle, C₁-C₃₀ alkylsulfonyle, C₃-C₃₀ alkylsulfonylalkyle, C₆-C₁₈ aryle, C₃-C₁₅ cycloalkyle, C₃-C₃₀ cycloalkylaminyle, C₅-C₃₀ cycloalkylalkylaminyle, C₅-C₃₀ cycloalkylalkyle, C₅-C₃₀ cycloalkylalkyloxy, C₁-C₁₂ hétérocyclyle, C₁-C₁₂ hétérocyclyloxy, C₁-C₃₀ hétérocyclylalkyloxy, C₁-C₃₀ hétérocyclylaminyle, C₅-C₃₀ hétérocyclylalkylaminyle, C₂-C₁₂ hétérocyclylcarbonyle, C₃-C₃₀ hétérocyclylalkyle, C₁-C₁₃ hétéroaryle ou C₃-C₃₀ hétéroarylalkyle ; Y est une quelconque ou plusieurs parmi des Ars ou des structures aromatiques ou des structures aromatiques condensées ou une combinaison de celles-ci.

8. Polymère électrochrome selon la revendication 7, dans lequel X dans l'unité à base de thiophène est O.

9. Polymère électrochrome selon la revendication 1, où le polymère électrochrome comprend une formule parmi : 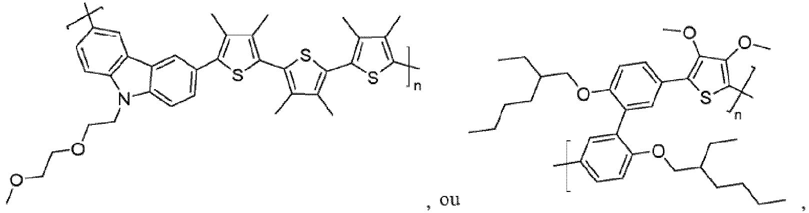 ou 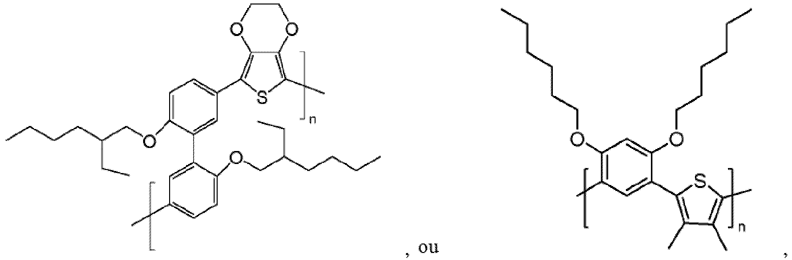 ou 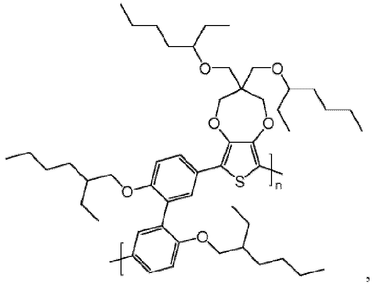 ou 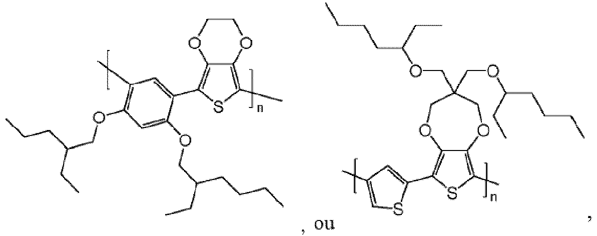 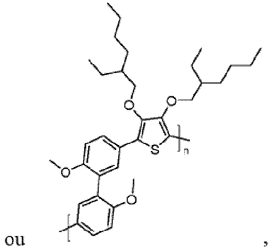 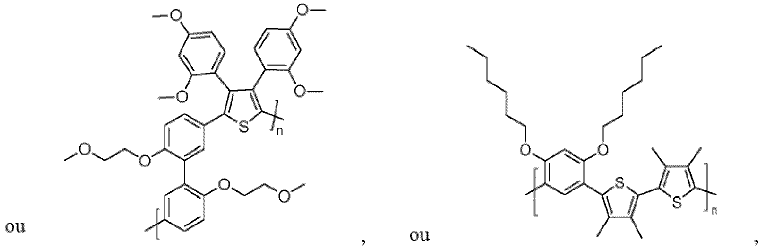 ou 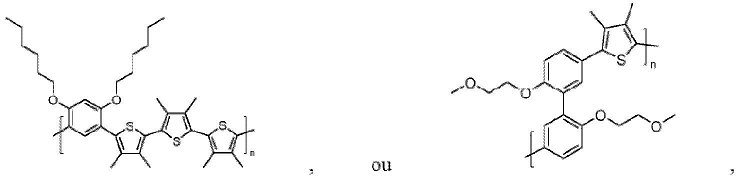 ou 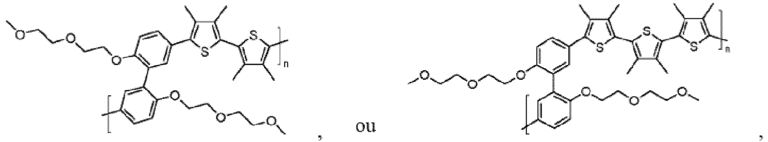 ou 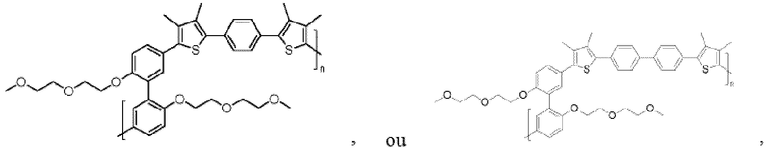 ou 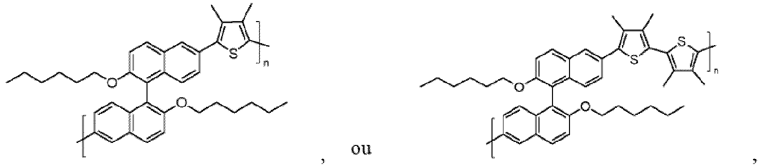 ou 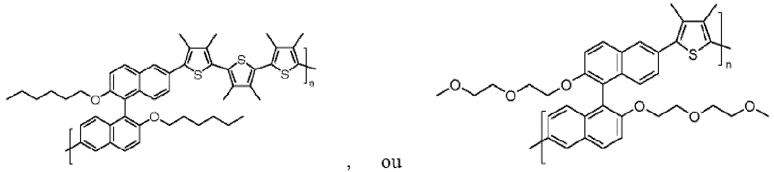 ou 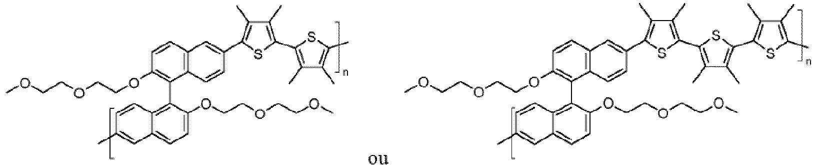 ou 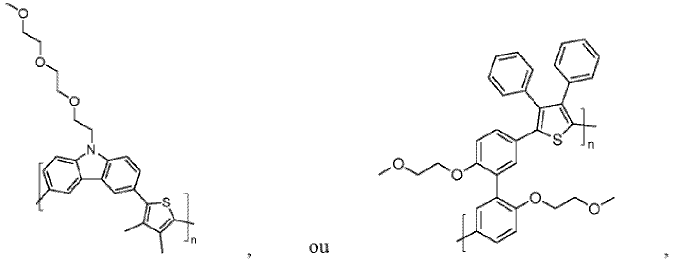 ou 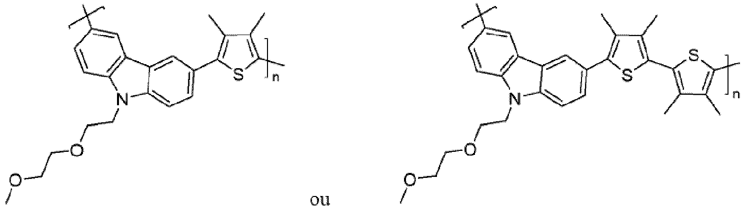 ou 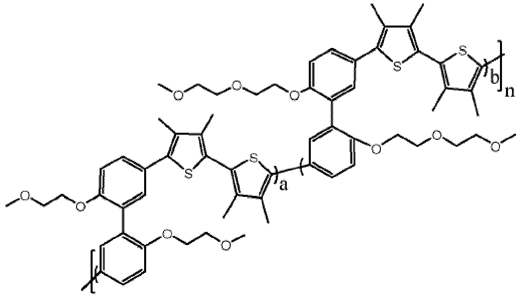 où n et m sont des nombres entiers supérieurs à 0, a et b sont des nombres entiers supérieurs ou égaux à 0, au moins un de a et b étant supérieur à 0.
